(19) Europäisches Patentamt
European Patent Office
Office européen des brevets

(11) EP 2 691 404 B1

(12) FASCICULE DE BREVET EUROPEEN

(45) Date de publication et mention de la délivrance du brevet:
**06.05.2015 Bulletin 2015/19**

(21) Numéro de dépôt: **12717404.3**

(22) Date de dépôt: **28.03.2012**

(51) Int Cl.:
***B82Y 10/00*** *(2011.01)* ***H01L 51/42*** *(2006.01)*

(86) Numéro de dépôt international:
**PCT/FR2012/050658**

(87) Numéro de publication internationale:
**WO 2012/131257 (04.10.2012 Gazette 2012/40)**

# (54) UTILISATION DE COMPLEXES DE COBALT POUR LA PRÉPARATION D'UNE COUCHE ACTIVE DANS UNE CELLULE PHOTOVOLTAÏQUE, ET CELLULE PHOTOVOLTAÏQUE CORRESPONDANTE

VERWENDUNG VON KOBALT KOMPLEXEN FÜR DIE HERSTELLUNG EINER AKTIVEN SCHICHT IN EINER PHOTOVOLTAISCHEN ZELLEN, UND EINE ENTSPRECHENDE PHOTOVOLTAISCHE ZELLE

USE OF COBALT COMPLEXES FOR THE PREPARATION OF THE ACTIVE LAYER OF A PHOTVOLTAIC CELL, AND CORRESPONDING PHOTOVOLTAIC CELL

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.03.2011 FR 1152641**

(43) Date de publication de la demande:
**05.02.2014 Bulletin 2014/06**

(73) Titulaires:
- **Centre National de la Recherche Scientifique 75016 Paris (FR)**
- **Université Pierre et Marie Curie (Paris 6) 75005 Paris (FR)**

(72) Inventeurs:
- **AUBERT, Corinne F-75012 Paris (FR)**
- **BERTRAND, Guillaume F-94200 Ivry-Sur-Seine (FR)**
- **FICHOU, Denis F-75014 Paris (FR)**
- **GANDON, Vincent F-91290 Arpajon (FR)**
- **MALACRIA, Max F-75012 Paris (FR)**
- **TORTECH, Ludovic F-91190 Gif Sur Yvette (FR)**

(74) Mandataire: **Goulard, Sophie et al**
**Ipsilon Brema-Loyer**
**Le Centralis**
**63, avenue du Général Leclerc**
**92340 Bourg-la-Reine (FR)**

(56) Documents cités:
**WO-A2-2004/008554**

- **ZHIHUA XU, ET AL.: "Improvement of photovoltaic response based on enhancement of spin-orbital coupling and triplet states in organic solar cells", JOURNAL OF APPLIED PHYSICS, vol. 103, 2008, pages 043909-1-043909-8, XP002653461, AIP**
- **G. A. CHAMBERLAIN: "Organic Solar Cells: A Review", SOLAR CELLS, vol. 8, 1983, pages 47-83, XP002653462, Elsevier**
- **ANAIS GENY, ET AL.: "Air Stable {(C5H5)Co} Catalysts for [2+2+2] Cycloaditions", ANGEWANDTE CHEMIE INTERNATIONAL EDITION, vol. 48, 2009, pages 1810-1813, XP002653463, Wiley-VCH**
- **M. D. RAUSCH, ET AL.: "Organometallic pi complexes. XXII. The Chemistry of pi-Cyclopentadienyltetraphenylcyclobutadie necobalt and Related Compounds", JOURNAL OF ORGANIC CHEMISTRY, vol. 35, 1970, pages 3888-3897, XP002653464, ACS**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

• E. BERGIN, ET AL.: "Application of the Suzuki reaction to the asymmetric desymmetrisation of 1,2- and 1,3-disubstituted bulky cobalt metallocenes", TETRAHEDRON: ASYMMETRY, vol. 21, 16 juin 2010 (2010-06-16), pages 1619-1623, XP002653465, Elsevier

## Description

La présente invention est relative à l'utilisation de complexes de cobalt à titre de donneur d'électrons pour la préparation d'une couche active (hétérojonction) dans une cellule de conversion photovoltaïque, ainsi que la cellule de conversion photovoltaïque multicouches comportant une couche active comprenant au moins un tel complexe de cobalt et au moins un accepteur d'électron.

Le domaine de l'invention peut être défini comme celui des semi-conducteurs organiques et notamment des hétérojonctions.

Les cellules photovoltaïques les plus répandues sont constituées de semi-conducteurs, principalement à base de silicium (Si) amorphe ou monocristallin. Elles se présentent généralement sous la forme de fines plaques d'une dizaine de centimètres de côté, prises en sandwich entre deux contacts métalliques, pour une épaisseur de l'ordre du millimètre. Les cellules à base de silicium les plus performantes comprennent une couche active de silicium monocristallin dont le rendement de conversion peut atteindre 40 % en laboratoire.

Bien que très performantes, les cellules photovoltaïques à base de silicium, et en particulier de silicium monocristallin, présentent l'inconvénient majeur d'être onéreuses en raison du coût élevé de cette matière première. C'est pourquoi une partie de la recherche se tourne vers les cellules à base de semi-conducteurs en couches minces.

En effet, la technologie couches minces permet de diminuer la quantité de semi-conducteurs utilisée et rend, de plus, possible l'utilisation de substrats de faible coût et de grande surface. Dans les cellules en couches minces, le silicium peut être du silicium amorphe ou du silicium cristallin, en général polycristallin. Cependant, les cellules de conversion photovoltaïques à base de couches minces en silicium amorphe sont sujettes à des problèmes de stabilité lorsqu'elles sont exposées au soleil. De plus, du fait de sa structure désordonnée, les propriétés de transport de charge du silicium amorphe sont médiocres, d'où un rendement médiocre. Ainsi une chute de rendement de 10 à 50 % de ces cellules se produit au cours des premières centaines d'heures d'exposition à la lumière des cellules à base de silicium amorphe.

Des cellules à base de semi-conducteurs organiques, et en particulier de composés organométalliques dont le coût de revient est moindre que celui du silicium ont déjà été proposées. Leur utilisation dans le domaine photovoltaïque est basée sur la capacité de certains polymères et oligomères $\pi$-conjugués, ou encore de certaines petites molécules $\pi$-conjuguées, à convertir l'énergie lumineuse en énergie électrique. Lorsqu'on constitue une jonction composée de deux semi-conducteurs de nature différente parmi lesquels au moins un est un composé organique, on définit ainsi une hétérojonction.

Les hétérojonctions comprenant un semi-conducteur organique de type p et un semi-conducteur organique ou inorganique de type n connaissent depuis plusieurs années de nombreuses applications dans le domaine de l'électronique plastique, et notamment dans celui particulier des cellules de conversion photovoltaïque. Généralement, dans celles-ci, le polymère, oligomères $\pi$-conjugué, ou la petite molécule $\pi$-conjuguée joue le rôle de donneur de type p et est mis(e) en présence d'un accepteur de type n tel que par exemple le fullerène, ou un dérivé de celui-ci. Sous irradiation lumineuse, une paire électron-trou est créée (exciton) sur le donneur d'électron. Cet exciton est dissocié par capture de l'électron par l'accepteur. Ces charges sont collectées aux électrodes et génèrent un courant électrique.

De nombreuses hétérojonctions ont ainsi déjà été proposées dans la littérature.

Vanlaeka et al. (Solar Energy Materials and Solar Cells, 2006, 90(14), 2150-2158) décrivent par exemple une hétérojonction pour cellules photovoltaïques organiques, constituée d'un mélange de poly(3-hexylthiophène) (P3HT) à titre de donneur d'électron et de [6,6]-phényl-C61-butyrate de méthyle (PCBM) à titre d'accepteur d'électrons. C. J. Brabec et al. (Synthetic Metals, 1999, 102, 861-864). F. Silvestri et al. (J. Am. Chem. Soc., 2008, 130, 17640-17641) décrivent la préparation d'hétérojonctions de cellules photovoltaïques à partir de solution de certains dérivés de squaraine utilisés à titre de donneurs d'électrons, en combinaison avec du PCBM. Ces cellules photovoltaïques ont cependant des rendements de conversion qui sont environ 50 % inférieurs à ceux des cellules à base de silicium.

Il a déjà été envisagé d'utiliser certains complexes métalliques afin d'améliorer les performances de ces cellules photovoltaïques. C'est ainsi que Z. Xu et al. par exemple (Journal of Applied Physics, 2008, 103, 043909-1-8) indiquent que les performances de conversion d'une hétérojonction composée d'un mélange de poly[2-méthoxy-5-(2'-éthylhexyloxy)-1,4-phénylènevinylène] (MEH-PPV) et de PCBM peuvent être améliorées par la présence de molécules phosphorescentes telles que $Ir(ppy)_3$ qui est un complexe d'iridium et de tris(2-phénylpyridine).

Enfin, il a déjà également été proposé, notamment par W. K. Chan et al. (Newsroom, 2009, 10.1117/2.1200908.1757) d'utiliser à titre de composé actif (donneur d'électron) d'une hétérojonction de dispositifs photovoltaïques, certains complexes de ruthénium, en mélange avec un fullerène à titre d'accepteur d'électrons. Ces dispositifs ne présentent cependant pas un bon rendement de conversion de l'énergie lumineuse en courant électrique. L'iridium et le ruthénium sont par ailleurs des éléments extrêmement rares et chers.

Enfin, il a déjà été proposé d'utiliser certains complexes métalliques à base de cobalt pour des applications en photovoltaïque tels que par exemple des phtalocyanines au cobalt, cependant ces composés se sont révélés moins efficaces que d'autres complexes métalliques tels que des complexes de nickel, de cuivre ou de zinc (Chamberlain G.

A., Solar Cells, 1983, 8, 47-83).

Xu Z, et. al, Journal of Applied Physics, 2008, 103, 043909-1 décrit une cellule de conversion photovoltaique comprenant un support (glass), une première électrode (ITO), une couche active comprenant un donneur d'électrons (MEH-PPV:Ir(ppy)3) et un accepteur d'électrons (PCBM) et une deuxième électrode (Al).

WO 2004/008554 A2 décrit des cellules de conversion photovoltaique comprenant une couche active comprenant un donneur d'électrons qui est un complexe de terres rares et un accepteur.

Il existe donc un besoin pour des composés ayant un prix de revient inférieur à celui du silicium et pouvant notamment être utilisés à titre donneur d'électrons pour la préparation d'une couche active dans une cellule de conversion photovoltaïque.

Les inventeurs ont maintenant découvert que certains complexes de cobalt dont la formule va être définie ci-après présentent d'excellentes propriétés de donneur d'électrons, ce qui leur permet d'être avantageusement utilisés, en combinaison avec un accepteur d'électron, pour la préparation d'une couche active (hétérojonction) dans une cellule de conversion photovoltaïque.

La présente invention a pour objet l'utilisation d'au moins un complexe de cobalt de formules (I-a) ou (I-b) suivante :

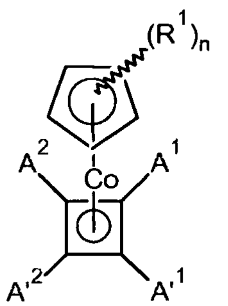
(I-a)

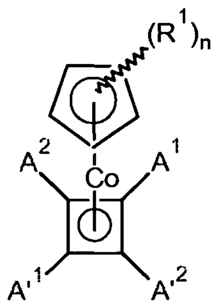
(I-b)

dans lesquelles :

- n est un entier variant de 0 à 5 ;
- $R^1$ est choisi parmi I, alkyle en $C_1$-$C_{12}$, triméthylsilyle, HgCl, -C(O)alkyle en $C_1$-$C_4$, et un groupement oxazole éventuellement substitué par un radical alkyle en $C_1$-$C_4$, étant entendu que lorsque n>1, tous les radicaux $R^1$ d'un composé de formule (I-a) ou (I-b) donné sont identiques,
- les groupements $A^1$, $A'^1$, $A^2$ et $A'^2$ sont identiques deux à deux et choisis parmi les groupements de formules (II-1) à (II-9) suivantes :

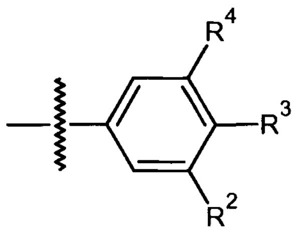
(II-1)

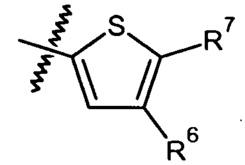
(II-2)

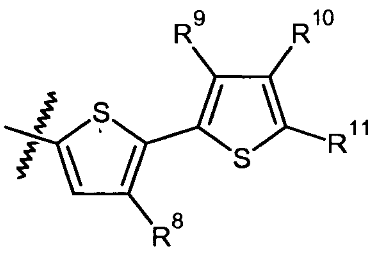
(II-3)

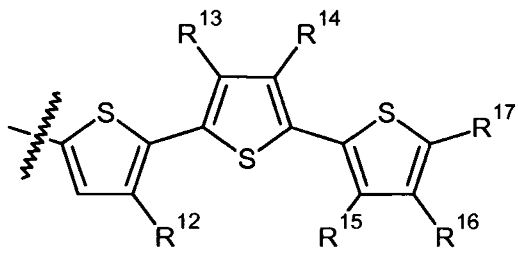
(II-4)

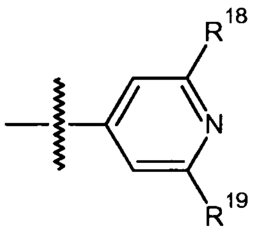

(II-5)

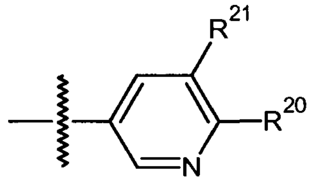

(II-6)

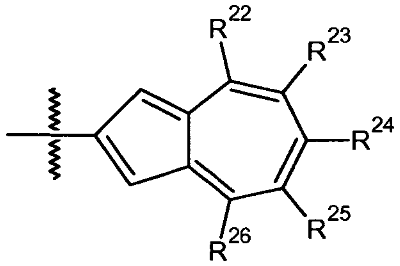

(II-7)

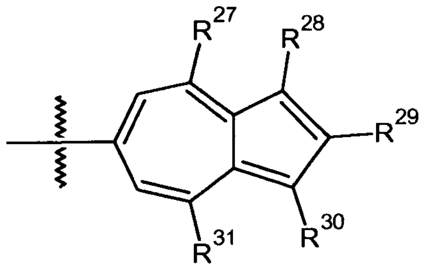

(II-8)

et

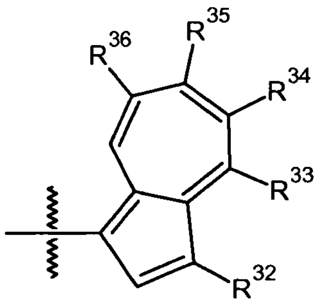

(II-9)

dans lesquels :

- $R^2$, $R^3$, et $R^4$, identiques ou différents, représentent un atome d'hydrogène, d'iode ou de brome, un radical nitro, alkyle linéaire en $C_1$-$C_{12}$, trifluorométhyle, dialkyl($C_1$-$C_4$)amino, -C(O)alkyle en$C_1$-$C_4$ ou alcoxy linéaire en $C_1$-$C_4$ ;

- $R^6$, $R^8$, $R^9$, $R^{10}$, $R^{12}$, $R^{13}$, $R^{14}$, $R^{15}$ et $R^{16}$, identiques ou différents, représentent un atome d'hydrogène ou de brome, un radical alkyle linéaire en $C_1$-$C_{12}$ ou alcoxy linéaire en $C_1$-$C_4$, $R^9$ et $R^{10}$ ensemble et/ou $R^{13}$ et $R^{14}$ ensemble et/ou $R^{15}$ et $R^{16}$ ensemble peuvent également former un groupement éthylènedioxy (-O-$(CH_2)_2$-O-).

- $R^7$, $R^{11}$ et $R^{17}$, représentent un atome d'hydrogène, de brome ou d'iode, un radical nitro, alkyle linéaire en $C_1$-$C_{12}$, alcoxy linéaire en $C_1$-$C_4$, -CHO, -C(O)alkyle en $C_1$-$C_4$, -C(O)alcoxy en $C_1$-$C_4$ ou un cycle thiophène portant éventuellement un ou plusieurs substituants choisis parmi Br, I, nitro, alkyle linéaire en $C_1$-$C_{12}$, alcoxy linéaire en $C_1$-$C_4$, -C(O)alkyle en $C_1$-$C_4$, et -C(O)alcoxy en $C_1$-$C_4$ ;

- $R^{18}$ à $R^{36}$, identiques ou différents, représentent un atome d'hydrogène, un radical alcoxy linéaire en $C_1$-$C_4$, un radical nitro ou -C(O)alcoxy en $C_1$-$C_4$,

à titre de donneur d'électron, et en combinaison avec un accepteur d'électron, pour la préparation d'une couche active (hétérojonction) dans une cellule de conversion photovoltaïque.

Les composés de formules (I-a) et (I-b) définis ci-dessus sont faciles d'accès, et en association avec un composé semi-conducteur de type n, tel que par exemple du [6,6]-phényl-C61-butyrate de méthyle (PCBM) ou autre, ils peuvent être déposés en couche humide et se révèlent être de très bons conducteurs de type *p*

Selon l'invention, l'expression «$A^1$, $A'^1$, $A^2$ et $A'^2$ sont identiques deux à deux » utilisées pour caractériser les groupements $A^1$, $A'^1$, $A^2$ et $A'^2$, signifie que dans chacun des composés de formule (I-a) et (I-b) $A^1 = A'^1$, $A^2 = A'^2$, et $A^1$ ($A'^1$) est identique ou différent de $A^2$ ($A'^2$).

Parmi les radicaux alkyle en $C_1$-$C_{12}$ mentionnés pour les radicaux $R^1$ à $R^{17}$, on peut plus particulièrement citer les radicaux méthyle, éthyle, n-propyle, n-butyle, n-pentyle et n-hexyle. Parmi ces radicaux, on préfère les radicaux méthyle et n-hexyle.

Parmi les radicaux alcoxy en $C_1$-$C_4$ mentionnés pour les radicaux $R^1$ à $R^{21}$, le radical méthoxy est préféré.

Selon une forme de réalisation préférée de l'invention, n est égal à 1 ou 2, et le ou les radicaux $R_1$ représente(nt) un radical méthyle.

Parmi les complexes de formules (I-a) et (I-b) ci-dessus, on peut en particulier citer :

- le [1,1', 1'', 1'''-(η4-1,3-cyclobutadiène-1,2,3,4-tetrayl)tetrakis-[benzène]] (η5-cyclopentadiényl)-cobalt(I) ;
- le [1,1', 1'', 1'''-(η4-1,3-cyclobutadiène-1,2,3,4-tetrayl)tetrakis-4-n-butyl-benzène]](η5-cyclopentadiényl)-cobalt(I) ;
- le [1,1',1'',1'''-(η4-1,3-cyclobutadiène-1,2,3,4-tetrayl)tetrakis-[3,5-diméthoxy-benzène]](η5-cyclopentadiényl)-cobalt(I) ;
- le [1,1'-[(1,2,3,4-η)-2,4-bis(4-méthoxybenzène)-1,3-cyclobutadién-1,3-diyl]bis[phényl]](η5-2,4-cyclopentadién-1-yl)-cobalt(I) ;
- le [1,1'-[(1,2,3,4-η)-2,4-bis(4-nitrobenzène)-1,3-cyclobutadién-1,3-diyl]bis[phényl]](η5-2,4-cyclopentadién-1-yl)-cobalt(I) ;
- le [1,1'-[(1,2,3,4-η)-2,4-bis(4-nitrobenzène)-1,3-cyclobutadièn-1,3-diyl]bis[4-méthoxy-benzène]](η5-2,4-cyclopentadién-1-yl)-cobalt(I) ;
- le [1,1'-[(1,2,3,4-η)-2,4-bis(4-bromobenzène)-1,3-cyclobutadièn-1,3-diyl]bis[4-méthoxy-benzène]](η5-2,4-cyclopentadièn-1-yl)-cobalt(I) ;
- le [1,1',1'', 1'''-(η4-1,3-cyclobutadiène-1,2,3,4-tetrayl)tetrakis-[4-benzoate de méthyl]](η5-cyclopentadiényl)-cobalt(I) ;
- le [1,1',1'', 1'''-(η4-1,3-cyclobutadiène-1,2,3,4-tetrayl)tetrakis-[2,2',5',bithiophène]]-(η5-cyclopentadiényl)-cobalt(I) ;
- le [1,1',1'',1'''-(η4-1,3-cyclobutadiène-1,2,3,4-tetrayl)tetrakis[2,2',5',2'',5''-ter-thiophène]](η5-cyclopentadiényl)-cobalt(I) ;
- le [1,1',1'',1'''-(η4-cyclobutadiène-tetrakis 1,2,3,4-[2,5,2',5',2''-ter-thiophène-5''-carbaldéhyde])]-(η5-cyclopentadiényl)-cobalt(I) ;
- le [1,1',1'',1'''-(η4-cyclobutadiène-tetrakis 1,2,3,4-[2,5,2',5',2''-ter-thiophène-5''-bromo])]-(η5-cyclopentadiényl)-cobalt(I) ;
- le 1,1',1'',1'''-(η4-cyclobutadiène-tetrakis 1,2,3,4-[2,5,2',5',2''-ter-thiophène-5''-méthoxy])]-(η5-cyclopentadiényl)-cobalt(I) ;
- le [1,1',1'',1'''-(η4-cyclobutadiène-tetrakis 1,2,3,4-[2,5,2',5',2''-ter-thiophène-5''-nitro])]-(η5-cyclopentadiényl)-cobalt(I) ;
- le [1,1',1'',1'''-(η4-cyclobutadiène-tetrakis 1,2,3,4-[2,5,2',5',2'-ter-thiophène-(4,4',4'')-tris hexyl])]-(η5-cyclopentadiényl)-cobalt(I) ;

- le [1,1',1",1'"-(η4-cyclobutadiène-tetrakis 1,2,3,4-[2,5,2',5',2"-ter-thiophène-5"-dodécyl])]-(η5-cyclopentadiényl)-cobalt(I) ;
- le [1,1',1",1'"-(η4-cyclobutadiène-tetrakis 1,2,3,4-[2,5,2',5',2"-terthiophène-5"-iodo])]-(η5-cyclopentadiényl)-cobalt(I) ;
- le [1,1',1",1"'-(η4-cyclobutadiène-bis 1,3-[2,5,2',5',2"-ter-thiophène-5"-nitro], bis 2,4-[2,5,2',5',2"-terthiophène-5"-méthoxy])]-(η5-cyclopentadiényl)-cobalt(I) ;
- le [1,1',1",1"'-(η4-cyclobutadiène-bis 1,3-[2,5,2',5',2"-ter-thiophène-5"-bromo], bis 2,4-[2,5,2',5',2"-terthiophène-5"-méthoxy])]-(η5-cyclopentadiényl)-cobalt(I) ;
- le [1,1',1",1"'-(η4-1,3-cyclobutadiène-1,2,3,4-tetrayl)tetrakis-[2-thionyl]] (η5-cyclopentadiényl)-cobalt(I) ;
- le [1,1',1",1"'-(η4-1,3-cyclobutadiène-1,2,3,4-tetrayl)tetrakis-[3-pyridyl]] (η5-cyclopentadiényl)-cobalt(I) ;
- le [1,1',1", 1"'-(η4-1,3-cyclobutadiène-1,2,3,4-tetrayl)tetrakis-[4-pyridyl]] (η5-cyclopentadiényl)-cobalt(I) ;
- le [1,1',1",1'"-(η4-1,3-cyclobutadiène-1,2,3,4-tetrayl)tetrakis-[1-azulényl] (η5-cyclopentadiényl)-cobalt(I) ;
- le [1,1',1",1"'-(η4-1,3-cyclobutadiène-1,2,3,4-tetrayl)tetrakis-[2-azulényl] (η5-cyclopentadiényl)-cobalt(I) ; et
- le [1,1',1",1"'-(η4-1,3-cyclobutadiène-1,2,3,4-tetrayl)tetrakis-[6-azulényl] (η5-cyclopentadiényl)-cobalt(I).

Parmi ces composés, on préfère tout particulièrement :

- le [1,1',1",1"'-(η4-1,3-cyclobutadiène-1,2,3,4-tetrayl)tetrakis-[2,2',5',bithiophène]]-(η5-cyclopentadiényl)-cobalt(I) ;
- le [1,1',1",1"'-(η4-1,3-cyclobutadiène-1,2,3,4-tetrayl)tetrakis[2,2',5',2",5"-ter-thiophène]](η5-cyclopentadiényl)-cobalt(I) ;
- le [1,1',1",1"'-(η4-cyclobutadiène-tetrakis 1,2,3,4-[2,5,2',5',2"-ter-thiophène-5"-carbaldéhyde])]-(η5-cyclopentadiényl)-cobalt(I) ;
- le [1,1',1",1"'-(η4-cyclobutadiène-tetrakis 1,2,3,4-[2,5,2',5',2"-ter-thiophène-5"-bromo])]-(η5-cyclopentadiényl)-cobalt(I) ;
- le 1,1',1",1"'-(η4-cyclobutadiène-tetrakis 1,2,3,4-[2,5,2',5',2"-ter-thiophène-5"-méthoxy])]-(η5-cyclopentadiényl)-cobalt(I) ;
- le [1,1',1",1'"-(η4-cyclobutadiène-tetrakis 1,2,3,4-[2,5,2',5',2"-ter-thiophène-5"-nitro])]-(η5-cyclopentadiényl)-cobalt(I) ;
- le [1,1',1",1"'-(η4-cyclobutadiène-tetrakis 1,2,3,4-[2,5,2',5',2'-ter-thiophène-(4,4',4")-tris hexyl])]-(η5-cyclopentadiényl)-cobalt(I) ;
- le [1,1',1",1"'-(η4-cyclobutadiène-tetrakis 1,2,3,4-[2,5,2',5',2"-ter-thiophène-5"-dodécyl])]-(η5-cyclopentadiényl)-cobalt(I) ;
- le [1,1',1",1"'-(η4-cyclobutadiène-tetrakis 1,2,3,4-[2,5,2',5',2"-ter-thiophène-5"-iodo])]-(η5-cyclopentadiényl)-cobalt(I) ;
- le [1,1',1",1'"-(η4-cyclobutadiène-bis 1,3-[2,5,2',5',2"-ter-thiophène-5"-nitro], bis 2,4-[2,5,2',5',2"-terthiophène-5"-méthoxy])]-(η5-cyclopentadiényl)-cobalt(I) ; et
- le [1,1',1",1"'-(η4-cyclobutadiène-bis 1,3-[2,5,2',5',2"-ter-thiophène-5"-bromo], bis 2,4-[2,5,2',5',2"-terthiophène-5"-méthoxy])]-(η5-cyclopentadiényl)-cobalt(I).

Les composés de formules (I-a) et (I-b) tels que définis ci-dessus, lorsqu'ils ne sont pas commerciaux, peuvent être préparés selon un procédé simple et peu couteux, comprenant les étapes suivantes :

a) la préparation d'un groupement de formule (III) suivante :

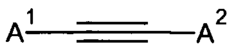

(III)

par couplage de Sonogashiri entre un groupement $A^1$-Br et un groupement $A^2$-Br, identiques ou différents, et tous deux choisis parmi l'un des groupements de formules (IV-1) à (IV-9) suivantes :

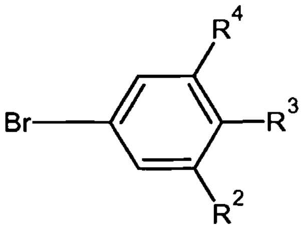

(IV-1)

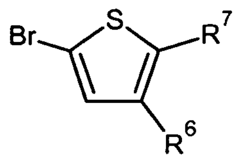

(IV-2)

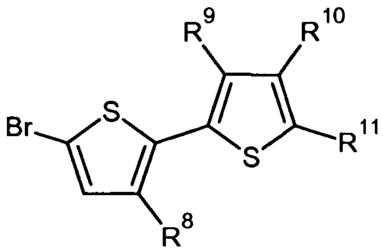

(IV-3)

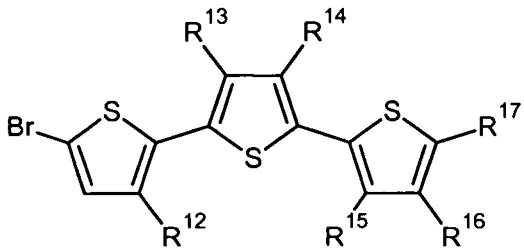

(IV-4)

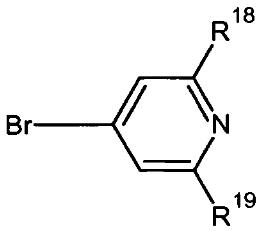

(IV-5)

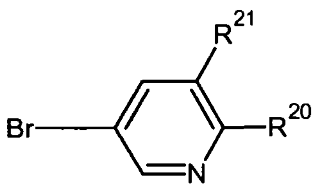

(IV-6)

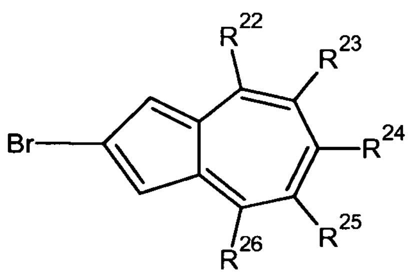

(IV-7)

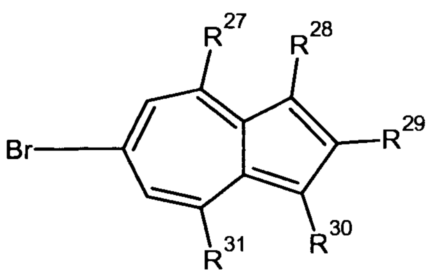

(IV-8)

,

et

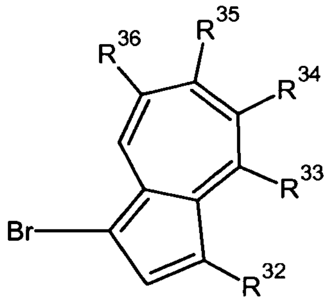

(IV-9)

dans lesquelles les radicaux $R^2$ à $R^{36}$ ont la même signification que celle indiquée ci-dessus pour les groupements de formules (II-1) à (II-9) ; ledit couplage étant réalisé dans un solvant organique de type amine, en présence de triméthylsilyléthyne (TMSA), d'une base organique ou d'un sel alcalin en solution dans un solvant organique, d'un complexe de palladium en tant que catalyseur et d'un sel de cuivre(I) en tant que co-catalyseur ;

b) la préparation d'un composé de formule (I-a) ou de formule (I-b) suivantes :

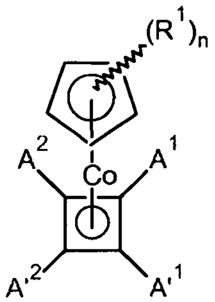

(I-a)

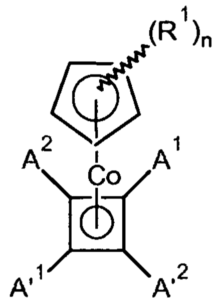

(I-b)

dans lesquelles n = 0 et les groupements $A^1$, $A'^1$, $A^2$ et $A'^2$ ont la même signification que celle indiquée ci-dessus, en faisant réagir le composé de formule (III) obtenu ci-dessus à l'étape a) avec un complexe de cobalt de formule (V) suivante :

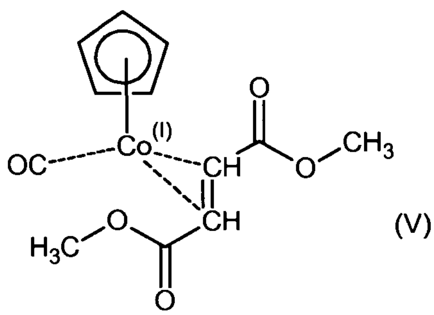

(V)

dans un solvant organique, à une température de 145 à 150°C, ladite réaction étant conduite en présence de micro-ondes d'une puissance de 60 à 120 W pendant une durée comprise de 30 min à 1 heure ; puis, lorsque l'on souhaite obtenir un composé de formule (I-a) ou (I-b) dans lequel $n \neq 0$,

c) la fonctionnalisation des composés de formule (I-a) et (I-b) par un ou plusieurs radicaux $R^1$, en faisant réagir le composé de formule (I-a) ou (I-b) dans lequel n = 0 obtenu ci-dessus à l'étape b), avec un composé de formule (VI) suivante :

$R^1$-X (VI)

dans laquelle :

- $R^1$ est choisi parmi alkyle en $C_1$-$C_{12}$, alcoxy en $C_1$-$C_4$, triméthylsilyle, C(O)alkyle en $C_1$-$C_4$, phosphane, et un groupement oxazole éventuellement substitué par un radical alkyle en $C_1$-$C_4$, et

- X représente un atome d'halogène choisi parmi le chlore et l'iode,

étant entendu que lorsque X = Cl, $R_1$ peut également représenter un groupement HgCl, et lorsque X = I, $R_1$ peut également désigner un atome d'iode ;
ladite fonctionnalisation étant réalisée dans un solvant et en présence d'un acide et d'un sel de mercure à titre de catalyseur, de chlorure de lithium et de n-butyl lithium, pour obtenir un composé de formule (I-a) ou (I-b) dans lequel $n \neq 0$.

Ce procédé est simple et peu couteux à mettre en oeuvre, et il permet d'accéder aux composés de formules (I-a) et (I-b) avec un très bon rendement.

Par ailleurs, l'utilisation des micro-ondes lors de l'étape b) permet de limiter la formation de sous-produits et d'augmenter la réactivité des produits de départ. Le produit désiré est ainsi obtenu avec un plus grand rendement, en moins de temps et de manière plus propre.

Le solvant de type amine utilisé lors de la réaction de couplage de Sonogashiri, (Sonogashira K. et al., Tetrahedron Letters, 1975, 4467) de l'étape a) pour la préparation des groupements de formule (III), peut être choisi parmi la triéthylamine et la diéthylamine.

Lorsqu'un sel alcalin est utilisé lors de l'étape a), celui-ci est de préférence du carbonate de potassium, en solution dans un mélange solvant constitué par du tetrahydrofurane et du méthanol.

Lorsqu'une base organique est utilisée lors de l'étape a), celle-ci peut notamment être choisie parmi le 1,8-diazabicyclo[5,4,0]undec-7-ène (DBU) et le ter-butanolate de potassium.

Le complexe de palladium utilisé à titre de catalyseur lors de l'étape a) est de préférence du dichlorure de bis(triphénylphosphine)palladium(II) $(Pd(Cl)_2(PPh_3)_2$ et le sel de cuivre utilisé en tant que co-catalyseur, du iodure cuivrique.

La durée de l'étape a) varie généralement de 1 à 12 heures environ.

Les groupements $A^1$-Br et $A^2$-Br de formule (IV-1) à (IV-9), utilisés lors de l'étape a), lorsqu'ils ne sont pas commercialement disponibles, peuvent être préparés, préalablement à l'étape a), selon les procédés bien connus de l' état de la technique et tels que décrits par exemple dans les publications suivantes :

- M. Lamberto et al, Tetrahedron Letters, 2005, 46(29), 4895-4899 ;
- S. Ito et al, J. Org. Chem., 2002, 67(21), 7295-7302 ;
- S. Ito et al, Tetrahedron Letters, 2004, 45(14), 2891-2894 ;
- K. M. Maloney, et al, Journal of Organic Chemistry, 2009, 74(14), 5111-5114.

A titre d'exemple, les groupements de formule (IV-4) peuvent être synthétisés selon un procédé consistant à faire réagir, dans un solvant organique, et en présence d'un catalyseur, de carbonate de potassium et de N-bromosuccinimide :

i) un composé de formule (VII) suivante :

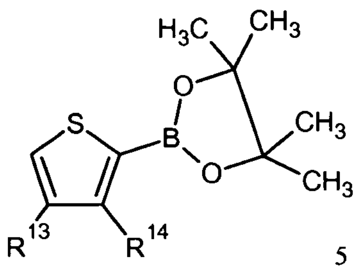

(VII)

avec un bromothiophène de formule (VIII) suivante :

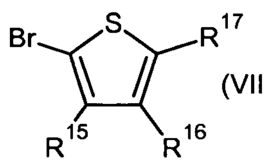

(VIII)

pour obtenir un composé de formule (IX) suivante :

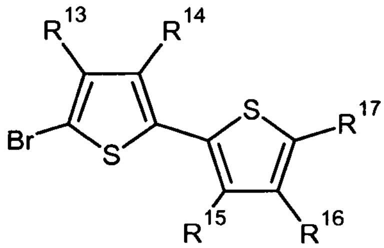

(IX)

formules (VII), (VIII) et (IX) dans lesquelles les radicaux $R^{13}$, $R^{14}$, $R^{15}$, $R^{16}$ et $R^{17}$ ont la même signification que celle indiquée ci-dessus pour les groupements de formule (II-4), puis

ii) le composé de formule (IX) obtenu ci-dessus à l'étape i) avec un composé de formule (X) suivante :

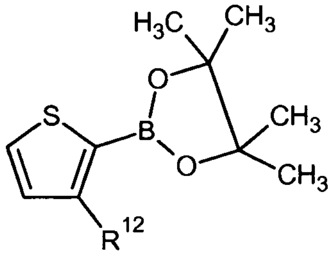

(X)

dans laquelle le radical $R^{12}$ a la même signification que celle indiquée ci-dessus pour les groupements de formule (II-4), pour obtenir le groupement de formule (IV-4) attendu.

Le solvant organique utilisé pour la préparation des groupements $A^1$-Br ou $A^2$-Br peut être choisi parmi le tetrahydrofurane (THF) et l'éther diéthylique.

Les composés de formules (VII), (VIII) et (IX) ci-dessus, lorsqu'ils ne sont pas commerciaux, peuvent être préparés selon des méthodes bien connues de l'homme du métier et telles que décrites par exemple dans les publications suivantes :

- J. B. Press et al., J. Org. Chem., 1979, 44(19), 3293 ;
- S. Kawamorita et al., J. Org. Chem., 2010, 75(11), 3855-3858 ;
- S. W. Hell et al., Angew. Chem. Int. Ed., 2006, 45, 7462-7465 ;
- A. H. M. Elwahy, et al, Euro. J. Org. Chem., 2010, 2, 265-27 ;
- A. H. M. Elwahy, et al, Tetrahedron Letters, 2000, 41(16), 2859-2862 ;
- E. M. Harcourt, et al, Organometallics, 2008, 27(7), 1653-1656 ; et
- U. S. Sorensen, and E. Pombo-Villar, Tetrahedron, 2005, 61(10), 2697-2703.

Le catalyseur utilisé pour la préparation des groupements $A^1$-Br ou $A^2$-Br est de préférence choisi parmi les catalyseurs au palladium tels que par exemple le tetrakis(triphénylphosphine)-palladium, le diacétate de palladium et le chlorure de bis-(triphénylphosphine)-palladium.

Le solvant organique utilisé lors de l'étape b) de préparation des composés de formules (I-a) ou (I-b) dans lesquelles n = 0 est de préférence choisi parmi l'éthanol, le diméthylformamide (DMF), le tetrahydrofurane (THF), le mélange THF (95% en volume)/éthanol (5% en volume), la pyridine, le mélange dichlorométhane (95 % en volume)/éthanol (5 % en volume), le mélange xylène (95 % en volume)/éthanol (5 % en volume) et le mélange toluène (95 % en volume)/éthanol (5 % en volume). Ces solvants sont classés dans l'ordre des puissances micro-ondes les plus faibles

au plus élevées qui sont nécessaires pour réaliser la réaction de l'étape b).

Ainsi, la puissance des micro-ondes appliquées lors de l'étape b) peut être ajustée en fonction de la nature du solvant utilisé. Par exemple, les puissances les plus faibles (proches de 60 W) peuvent être utilisées lorsque le solvant est l'éthanol ou le DMF, alors que les puissances les plus élevées (de l'ordre de 120 W environ) sont préférées lorsque le solvant est un mélange xylène (95 % en volume)/éthanol (5 % en volume) ou un mélange toluène (95 % en volume)/éthanol (5 % en volume).

Le solvant utilisé à l'étape c) de fonctionnalisation des composés de formule (I-a) et (I-b) dans lesquels n = 0, par un ou plusieurs radicaux $R^1$ est de préférence du tetrahydrofurane ou du dioxane.

Parmi les acides utilisables lors de l'étape c), on peut notamment citer l'acide perchlorhydrique.

Parmi les sels de mercure utilisables lors de l'étape c), on peut notamment citer l'acétate de mercure, et le dichlorure de mercure.

Lors de l'étape c), le nombre de radicaux $R^1$ substituant le cycle pentadiényle des composés de formule (I-a) ou (I-b), c'est-à-dire la valeur de n, peut être choisie en ajustant le nombre d'équivalents de sel de mercure et d'alkyle lithié.

Ce procédé est simple, reproductible et peu coûteux à mettre en oeuvre et conduit à l'obtention des complexes de formule (I-a) ou (I-b) avec un rendement de l'ordre de 65 à 95 %.

Entre chacune des étapes de synthèse, les composés intermédiaires sont de préférence purifiés par toute technique appropriée et connue de l'homme du métier, par exemple par passage sur une colonne de chromatographie.

Comme on l'a vu précédemment les complexes de formule (I-a) et -I-b) sont de très bons semi-conducteurs et peuvent ainsi être utilisés à titre de donneur d'électron pour la préparation d'une hétérojonction d'une cellule de conversion photovoltaïque.

L'invention a donc également pour objet une cellule de conversion photovoltaïque comprenant au moins un support, une électrode positive, une couche active (hétérojonction) comprenant au moins un donneur d'électrons et au moins un accepteur d'électrons, et une électrode négative, ladite cellule étant caractérisée en ce que le donneur d' électrons est choisi parmi les composés de formule (I-a) et (I-b) tels que définis ci-dessus.

L'accepteur d'électrons est de préférence choisi parmi les dérivés de fullerène (C60, C70) tels que le [6, 6]-phényl-C61-butyrate de méthyle (PCBM), les nanotubes de carbone, les dérivés du pérylène et les dérivés du tetracyanoquinodiméthane (TCNQ).

Selon une forme de réalisation préférée, le rapport massique composé de formule (I-a) ou (I-b)/accepteur d' électrons varie de 2/1 à 1/4.

Selon l'invention, le substrat est de préférence un substrat transparent en un matériau qui peut être souple ou rigide, par exemple du verre, et sur lequel se trouve déposée une électrode positive, constituée d'oxyde de métaux par exemple d'oxyde d'indium étain (ITO selon la dénomination anglophone « *Indium Tin Oxide »).*

L'électrode négative est de préférence une électrode d'aluminium.

Selon une forme de réalisation préférée de l'invention, une couche tampon est intercalée entre la couche active et l'électrode positive afin d'améliorer l'interface entre ces deux couches. Une telle couche tampon peut notamment être constituée d'une couche d'un mélange de deux polymères : le poly(3,4-éthylènedioxythiophène) (PEDOT) et le poly(styrène sulfonate) de sodium (PSS) : couche PEDOT :PSS.

De manière également préférée, une couche tampon est également intercalée entre la couche active et l' électrode négative afin d'améliorer là également l'interface entre ces deux couches. Une telle couche tampon peut notamment être constituée d'une couche de fluorure de lithium (LiF).

La cellule photovoltaïque conforme à l'invention peut être préparée selon les techniques connues de l'homme du métier, et notamment selon un procédé consistant à déposer, sur une électrode positive préalablement recouverte d'une couche tampon, une solution d'au moins un composé de formule (I) et d'au moins un accepteur d'électrons dans un solvant approprié tel que par exemple le dichlorobenzène. Le dépôt de la couche active peut être fait par toute technique appropriée, et de préférence par enduction centrifuge (« spin-coating »).

Le dépôt d'une seconde couche tampon sur la couche active puis de l'électrode négative, peut également être fait par toute technique appropriée et connue de l'homme du métier, et en particulier par dépôt en phase gazeuse.

La présente invention est illustrée par les exemples de réalisation suivants, auxquels elle n'est cependant pas limitée.

## EXEMPLES

Les matières premières suivantes ont été utilisées dans les exemples :

- 2,2':5',2''-terthiophène ; 2-(carboxaldéhyde)-(5,2'-bithiophène) ; 2-iodo-(5,2'-bithiophène) vendus par la société TCI Chemicals ;

- Méthanol ; N-iodo-succinimide ; Benzène ; Diazabicyclo[5,4,0]undec-7-ène (DBU) ; Butyl-lithium ; Hexane ; 4-méthoxy-iodobenzène ; 4-nitro-iodobenzène ; Méthyl ester de l'acide 4-iodo-benzoïque ; vendus par la société Sigma Aldrich ;

- Ether de pétrole ; Dichlorométhane ; Toluène ; Ethanol ;Tetrahydrofurane (THF) ; triphénylphosphine vendus par la société VWR ;
- Chlorure de bis(triphénylphosphine)palladium(II) ; Triméthylsilyl-acétylène (TMSA) ; Bis(benzène)-acétylène ; tetrabromométhane ; 3,5-diméthoxy benzaldéhyde ; 3,5-diméthoxy-iodobenzène ; Ethynyl-benzène ; Tetrabromométhane vendus par la société Acros ;
- Iodure cuivrique (CuI) ; Biscarbonyl, cyclopentadiènyl cobalt (I), vendus par la société Strem ;
- Diméthylfumarate ; Bis[4-n-butyl-benzène]acétylène vendus par la société Alfa Aezer ;
- PEDOT :PSS : Poly(3,4-éthylènedioxythiophène) poly(styrènesulfonate) vendu par la société Sigma Aldrich ;
- PCBM : [6,6]-phényl-C61-butyrate de méthyle vendu par la société Sigma Aldrich.

**EXEMPLE 1**

1) **Synthèse du [1,1',1",1"'-(η4-cyclobutadiène-1,2,3,4-tetrayl)tetrakis[2,2',5', 2", 5"-terthiophène]](η5-cyclopentadiényl)-cobalt(I)**

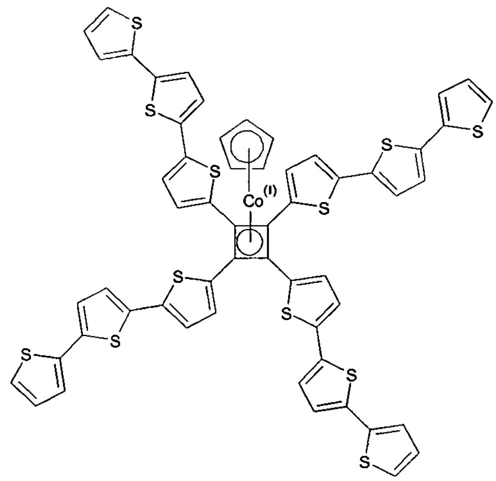

1) Première étape : Synthèse du 2-iodo-(5,2':5',2"-terthiophène)

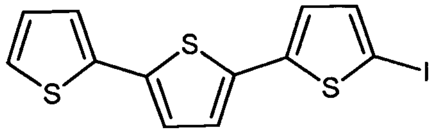

(1)

500 mg (2,02 mmol) du produit commercial (2,2':5',2"-terthiophène) ont été dilués dans 100 ml de méthanol à 0°C. 1,1 équivalent de N-iodo-succinimide (NIS, 546 mg, 2,1 mmol) ont ensuite été ajoutés. Le mélange a été laissé sous agitation, dans l'obscurité pour 12 h. Le solvant a ensuite été évaporé sous pression réduite. Le brut de la réaction a alors été purifié par chromatographie sur colonne en utilisant comme éluant de l'éther de pétrole puis un mélange éther de pétrole/dichlorométhane (5/1 : v/v). Le produit attendu a été isolé sous forme d'une poudre jaune (285 mg ; rendement = 45%).

2) Deuxième étape : Synthèse du bis (2,2':5,2"-terthiophène)acélylène

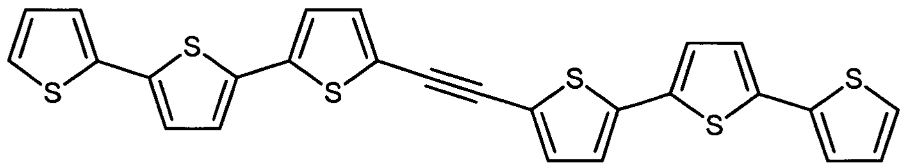

(2)

150 mg (0,4 mmol) de 2-iodo(5,2':5',2"-terthiophène) obtenu ci-dessus à l'étape précédente, ont été introduits dans un ballon ainsi que 9 mg de Chlorure de bis(triphénylphosphine)palladium(II) ($Pd(Cl_2)(PPh_3)_2$) (24 μmol) et 8 mg de CuI (40 μmol). Le ballon a ensuite été purgé 3 fois (vide/argon). 50 ml de benzène distillé, 0,8 ml de DBU (7 équivalents, 2,8 mmol), 29 μl de TMSA (0,5 équivalent, 0,2 mmol) et 3 μl d'eau distillée (0,4 éq., 0,16 mmol) ont été ajoutés dans cet ordre au milieu réactionnel. Le mélange a été laissé 24 h sous agitation dans l'obscurité à température ambiante. Le solvant a ensuite été évaporé sous pression réduite, puis le brut a été purifié par passage sur une colonne chromatographique (éluant : éther de pétrole 1 L / dichlorométhane 3 L). Le produit a été isolé sous forme d'une poudre marron foncé (82 mg, rendement : 32%). Ce composé a été directement engagé dans la réaction décrite ci-dessous à la quatrième étape.

3) Troisième étape : Synthèse du (η2-diméthylfumarate), carbonyle, η5 cyclopentadiényl cobalt (I).

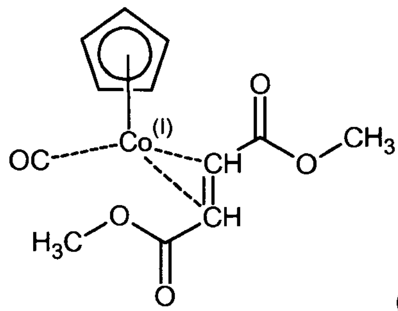

(3)

1,44g (10 mmol) de diméthylfumarate ont été dissous dans 150 ml de toluène distillé contenu dans un ballon. Le ballon a alors été purgé 3 fois avec de l'argon. Puis 1,4 ml (10mmol) de biscarbonyl, cyclopentadiènyl cobalt (I) ont été ajoutés et le mélange réactionnel a été agité au reflux du toluène sous irradiation (simple lampe halogène) pour une durée de 6 h. Le solvant a été évaporé sous pression réduite. Le brut de la réaction a ensuite été purifié par chromatographie sur colonne : (éluant éther de pétrole 3-1 Acétate d'éthyle (v/v)). Le produit a alors été isolé sous la forme d' une poudre rouge (m = 1,98 mg, rendement : 66%) :

RMN $^1H$ (400 MHz, $CDCl_3$) δ 3,28 (d, J = 10,3Hz, 1 H) ; 3,61 (s, 3 H) ; 3,71 (s, 3 H) ; 3,86 (d, J = 10,3 Hz, 1 H) ; 4, 99 (s, 5 H).

RMN $^{13}C$ (101 MHz, $CDCl_3$) δ 37,1 ; 38,2; 51,4; 51,5; 87,2; 175,6; 176,2 ; 199,2. Ce spectre est en accord avec ceux de la littérature : A. Geny, *et al.,* Ang. Chem. Int Ed., 2009, **48**(10), 1810-1813.

4) Quatrième étape : Synthèse du [1,1',1",1"'-(η4-cyclobutadiène-1,2,3,4-tetrayl)tetrakis[2,2',5',2",5"-terthiophène]](η5-cyclopentadiényl)-cobalt(I)

Dans un tube scellé, 42 mg (2 éq., 82 μmol) de bis-(2,2':5',2"-terthiophène)acétylène obtenu ci-dessus à la deuxième étape et 18 mg de ((η2-diméthylfumarate)carbonyle, η5-cyclopentadiényl)-cobalt (I) (1,5 équivalent, 61 μmol) ont été dilués dans 1 ml d'éthanol et 14 ml de THF. Le milieu réactionnel a été chauffé à 150°C au micro-onde (90 watts régime stationnaire) pendant 45 min. Les solvants ont ensuite été évaporés sous pression réduite, puis le brut a été filtré avec de l'éthanol (25 ml). Le gâteau résultant a été filtré avec du dichlorométhane, pour donner le produit attendu sous forme d'une poudre noir (25 mg, rendement : 45%).

RMN $^1H$ (400 MHz, $CDCl_3$) $\delta$ 7,23 (d, J = 5,1 ; 4H) ; 7,19 (d, J = 3,6 ; 8H) ; 7,10 (dd, J = 3,7 ; 8,9 ; 8H) ; 7,05 - 7,00 (m, 8H) ; 4,86 (s, 5H).

RMN $^{13}C$ (101 MHz, $CDCl_3$) $\delta$ 137,30 ; 137,04 ; 136,74 ; 136,33 ; 136,26 ; 128,11 ; 128,08 ; 124,64 ; 124,60 ; 124,33 ; 124,11 ; 123,83 ; 84,02 ; 69,68.

Le spectre d'absorption du composé (**1**) a été mesuré avec un spectrophotomètre UV-Visible vendu par la société Perkin Elmer sous la référence Lambda 650, en solution à 0,1 mg/ml (85 $\mu$mol/L) dans le dichlorométhane. Il est reporté sur la figure 1 annexée sur laquelle l'absorbance en unités arbitraires est fonction de la longueur d'ondes en nm ($\lambda_{max}$ = 399 nm ; $\varepsilon$ = 9,3.10$^4$ cm$^{-1}$.L.mol$^{-1}$ ; Egap = 1,9eV).

**EXEMPLE 2**

**<u>Synthèse du [1,1',1",1"'-(η4-cyclobutadiène-tetrakis 1,2,3,4-[2,5,2',5',2" terthiophène-5"-carbaldéhyde])]-(η5-cyclopentadiényl)-cobalt(I)</u>**

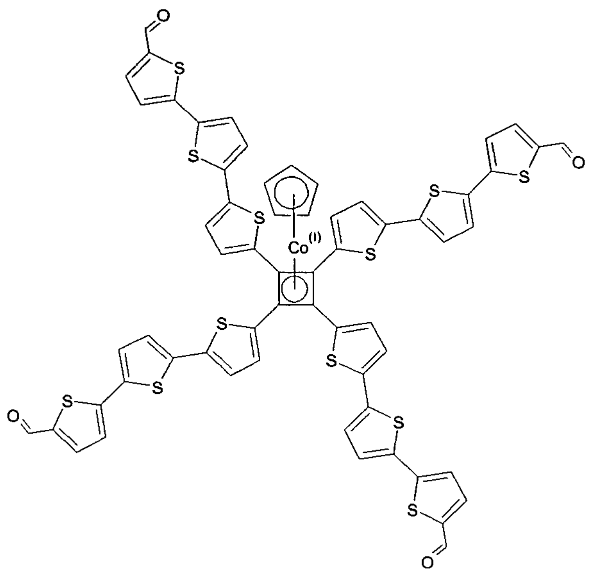

Le 2-bromo-(2,2':5',2"-terthiophène-5"-carbaldéhyde) de formule suivante était commercialement disponible chez TCI Chemicals :

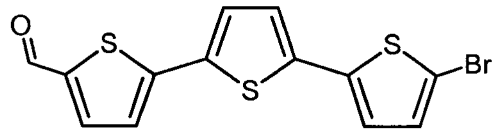

(4)

<u>2) Première étape : Synthèse du bis (2,2':5',2"-terthiophène-5"-carbaldéhyde)acétylène</u>

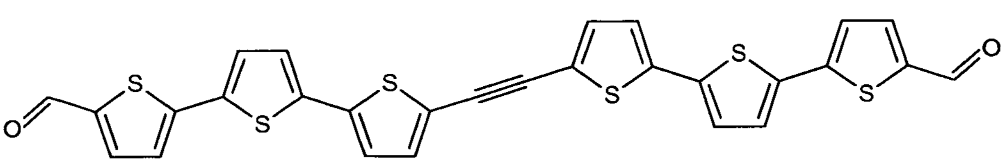

(5)

120 mg (0,34 mmol) de 2-bromo-(2,2':5',2"-terthiophène-5"-carbaldéhyde) (4) (TCI Chemicals), 10 mg de chlorure de bis(triphénylphosphine)palladium(II) ($Pd(Cl_2)(PPh_3)_2$) (30 $\mu$mol) et 8 mg de CuI (40 $\mu$mol) ont été introduits dans

un ballon. Le ballon a ensuite été purgé 3 fois (vide/argon). 50 ml de benzène distillé, 0,75 ml de DBU (7 équivalents, 2,4 mmol), 23 μl de TMSA (0,5 équivalent, 0,16 mmol) et 3 μl d'eau distillée (0,4) ont ensuite été ajoutés, dans cet ordre, au milieu réactionnel. Le mélange a été laissé 24 h sous agitation dans l'obscurité à température ambiante. Le solvant a ensuite été évaporé sous pression réduite, puis le brut a été purifié par passage sur une colonne chromatographique (éluant : dichlorométhane 5 L). Le produit attendu a été isolé sous forme d'une poudre marron foncé (36 mg, rendement : 39%). Ce composé a été directement engagé dans la réaction décrite ci-dessous.

<u>3) Deuxième étape : Synthèse du [1,1',1",1"'-(η4-cyclobutadiène-tetrakis 1,2,3,4-[2,5,2',5',2"-terthiophène-5"-carbaldéhyde])]-(η5-cyclopentadiényl)-cobalt(I)</u>

Dans un tube scellé, 36 mg (2 éq., 62 μmol) de bis (2,2':5',2"-terthiophène-5"-carbaldéhyde)acétylène obtenu ci-dessus à la première étape et 14 mg de ((η2-diméthylfumarate)carbonyle, η5-cyclopentadiényl)-cobalt (I) (1,5 équivalent, 45 μmol) ont été dilués dans 1 ml d'éthanol et 14 ml de THF. Le milieu réactionnel a été chauffé à 150°C au micro-onde (90 watts régime stationnaire) pendant 45 min. Les solvants ont ensuite été évaporés sous pression réduite, puis le brut a été filtré avec de l'éthanol (25 ml). Le gâteau résultant a été filtré avec du dichlorométhane, pour donner le produit attendu sous forme d'une poudre noire (10 mg, rendement : 26%).

RMN $^1H$ (400 MHz, $CDCl_3$) δ 9,06 (s, 4H) 7,36 (d, J = 5,8 ; 4H) ; 7,29 (d, J = 3,5 ; 8H) ; 7,15 (dd, J = 3,5 ; 8,6 ; 8H) ; 7,09 - 7,00 (m, 8H) ; 4,91 (s, 5H).

RMN$^{13}C$ (101 MHz, $CDCl_3$) δ 187,90 ; 148,11 ; 139,01 ; 137,21 ; 137,00 ; 136,87 ; 129,38 ; 128,98 ; 126,66 ; 126,49 ; 125,92 ; 125,61 ; 124,73 ; 86,86 ; 70,00.

**EXEMPLE 3**

<u>**Synthèse du [1,1',1",1"'-(η4-cyclobutadiène-tetrakis 1,2,3,4- [2,5,2',5',2"-terthiophène-5"-bromo])]-(η5-cyclopentadiényl)-cobalt(I)**</u>

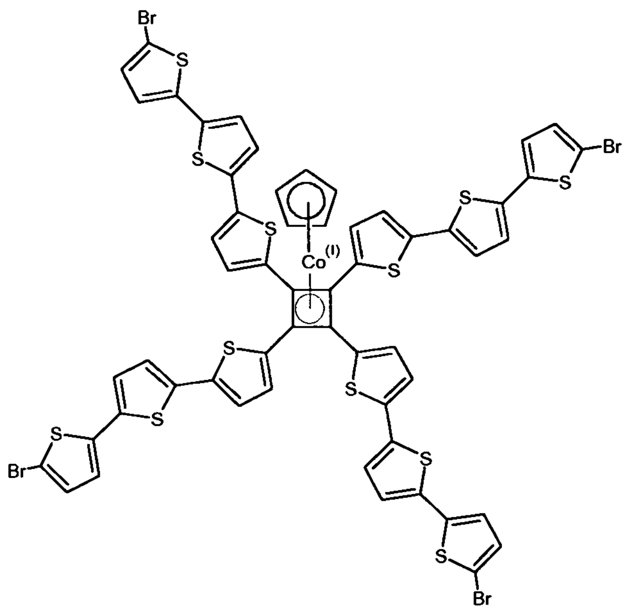

<u>1) Première étape Synthèse du 2 iodo, 5"-bromo (5,2':5',2"-terthiophène) (composé n° 5) :</u>

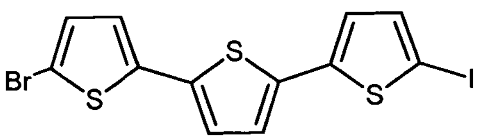

(5)

100 mg (0,27 mmol) de 2-iodo-(5,2':5',2"-terthiophène) (**1**) obtenu ci-dessus à la première étape de l'exemple 1 ont été dilués dans 100 ml de méthanol à 0°C. 2 équivalents de N-bromo-succinimide (NBS, 95 mg, 0,53 mmol) ont ensuite été ajoutés. Le mélange a été laissé sous agitation, dans l'obscurité pour 12 h. Le solvant a ensuite été évaporé sous pression réduite. Le brut de la réaction a alors été purifié par chromatographie sur colonne en utilisant comme éluant de l'éther de pétrole puis un mélange éther de pétrole/dichlorométhane (5/1 : v/v). Le produit attendu a été isolé sous forme d'une poudre jaune (115 mg ; rendement = 95%).

2) Deuxième étape : Synthèse du bis-(2,2':5',2"-terthiophène-5"-bromo)acétylène (composé **6**)

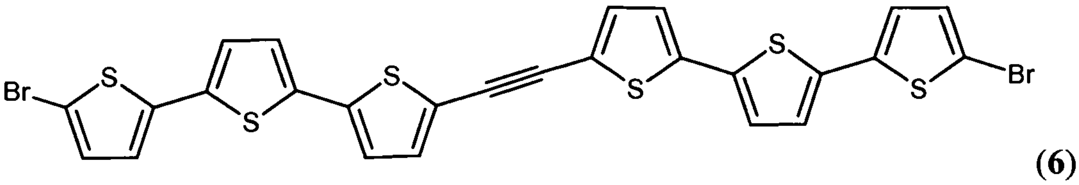

**(6)**

115 mg (0,25 mmol) de 2-iodo, 5"-bromo (5,2':5',2"-terthiophène) (**5**) obtenu ci-dessus à l'étape précédente, ainsi que 10 mg de chlorure de bis(triphénylphosphine)palladium(II) ($Pd(Cl_2)(PPh_3)_2$) (30 μmol) et 8 mg de CuI (40 μmol) ont été introduits dans un ballon. Le ballon a ensuite été purgé 3 fois (vide/argon). 50 ml de benzène distillé, 0, 36 ml de DBU (7 équivalents, 1,75 mmol), 15 μl de TMSA (0,5 équivalent, 0,13 mmol) et 3 μl d'eau distillée (0,4 éq) ont été ajoutés dans cet ordre au milieu réactionnel. Le mélange a été laissé 24 h sous agitation dans l'obscurité à température ambiante. Le solvant a ensuite été évaporé sous pression réduite, puis le brut a été purifié par passage sur une colonne chromatographique (éluant : dichlorométhane 5 L). Le produit a été isolé sous forme d'une poudre marron foncé (44 mg, rendement : 49%). Ce composé a été directement engagé dans la réaction suivante.

3) Troisième étape : Synthèse du [1,1',1",1"'-(η4-cyclobutadiène-tetrakis 1,2,3,4-[2,5,2',5',2"-terthiophène-5"-bromo]]-(η5-cyclopentadiényl)-cobalt(I)

Dans un tube scellé, 44 mg (2 éq., 0,06 μmol) de bis-(2,2':5',2"-terthiophène-5"-bromo)acétylène (**6**) obtenu ci-dessus à la deuxième étape et 15 mg du composé (**3**) obtenu ci-dessus à l'étape 3) de l'exemple 1 (1,5 équivalent, 0,04 μmol) ont été dilués dans 1 ml d'éthanol et 14 ml de THF. Le milieu réactionnel a été chauffé à 150°C au micro-onde (90 watts régime stationnaire) pendant 45 min. Les solvants ont ensuite été évaporés sous pression réduite, puis le brut a été filtré avec de l'éthanol (25 ml). Le gâteau résultant a été filtré avec du dichlorométhane, pour donner le produit attendu sous forme d'une poudre noire (30 mg, rendement : 32%).

RMN $^1H$ (400 MHz, $CDCl_3$) δ 7,26 (d, J = 3,6 ; 8H) ; 7,16 (dd, J = 3,5 ; 8,4 ; 8H) ; 7,23 - 6,99 (m, 8H) ; 4,85 (s, 5H).

RMN$^{13}C$ (101 MHz, $CDCl_3$) δ 132,77 ; 131,86 ; 131,12 ; 130,58 ; 130,07 ; 126,36 ; 126,08 ; 125,08 ; 124,38 ; 123,91 ; 123,67 ; 123,19 ; 85,31 ; 68,40.

**EXEMPLE 4**

**Synthèse du [1,1',1",1"'-(η4-1,3-cyclobutadiène-1,2,3,4-tetrayl)tetrakis [benzène]](η5-cyclopentadiényl)-cobalt(I)**

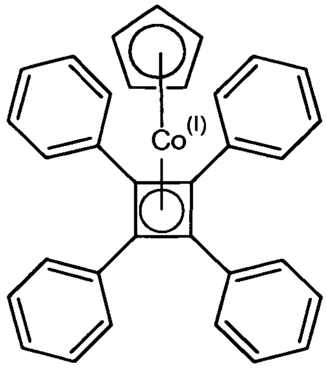

Dans un tube scellé, 45 mg de diphényl-acétylène (2 équivalents, 250 μmol) et 49 mg du composé (**3**) tel que préparé ci-dessus à l'étape 3) de l'exemple 1 ont été dilués dans 1 ml d'éthanol et 14 ml de THF. Le milieu réactionnel a été chauffé à 150°C au micro-onde (90 watts, régime stationnaire) pendant 45 min. Les solvants ont ensuite été évaporés sous pression réduite, puis le brut a été filtré avec de l'éthanol (25 ml). Le gâteau résultant a été filtré avec du dichlorométhane. Le filtrat de cette deuxième filtration a été concentré sous pression réduite pour donner une poudre jaune du produit attendu (60 mg, rendement 99 %).

RMN $^1H$ (400 MHz, $CDCl_3$) δ 4,65 (s, 5 H) ; 7,20-7,26 (m, 12 H) ; 7,46-7,48 (m, 8 H).

RMN $^{13}C$ (101 MHz, $CDCl_3$) δ 75,0 (4C) ; 83,3 (5C) ; 126,3 (4C) ; 128,0 (8C) ; 129,0 (8C) ; 136,6 (4C). Ces spectres sont en accord avec ceux précédents dans la littérature : A. Geny et al., Ang. Chem. Int Ed., 2009, 48(10), 1810-1813.

## EXEMPLE 5

**Synthèse du [1,1',1",1"'-(η4-1,3-cyclobutadiène-1,2,3,4-tetrayl)tetrakis[ 4-n-butyl-benzène]](η5-cyclopentadiényl)-cobalt(I)**

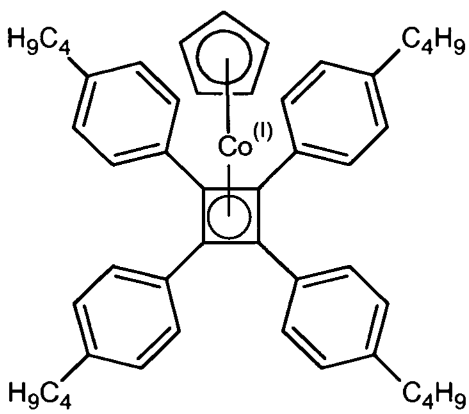

Le protocole général de complexation/cyclisation [2+2] mis en oeuvre ci-dessus à l'exemple 4 a été ici appliqué sur 250 mg (0,98 mmol) de bis[4-n-butyl-benzène]acétylène et 185 mg (0,62 mmol) composé (**3**) tel que préparé ci-dessus à l'étape 3) de l'exemple 1, pour donner le produit attendu sous forme d'une poudre jaune (330 mg, rendement = 95%).

RMN $^1H$ (400 MHz, $CDCl_3$) δ 7,37 (d, *J* = 8,0 Hz, 8H) ; 7,02 (d, *J*= 8,0 Hz, 8H) ; 4,61 (s, 5H) ; 2,58 (dd, *J* = 8, 0 Hz, 8H) ; 1,65 (dt, *J* = 15,4 ; 7,6 Hz, 8H) ; 1,46 - 1,36 (m, 12H) ; 0,97 (t, *J* = 7,3 Hz, 2H).

RMN $^{13}C$ (101 MHz, $CDCl_3$) δ 140,63 ; 133,86 ; 128,72 ; 127,83 ; 83,00 ; 74,79 ; 35,60 ; 33,35 ; 22,58 ; 14,03.

**EXEMPLE 6**

**Synthèse du [1,1',1",1"'-(η4-1,3-cyclobutadiène-1,2,3,4-tetrayl)tetrakis[3,5 diméthoxy-benzène]](η5-cyclopentadiényl)-cobalt(I)**

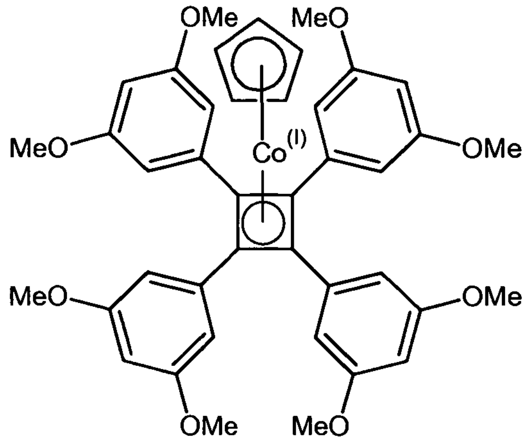

1) Première étape : Synthèse du 1-(2,2-dibromo-vinyl)-3,5-diméthoxy-benzène (7)

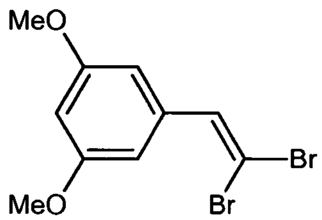

(7)

2,9 g (9 mmol) de tetrabromométhane ont été solubilisés avec 20 ml de dichlorométhane distillé dans un premier ballon purgé trois fois vide/argon. 4,39 g de triphénylphosphine ont été solubilisés avec 20 ml de dichlorométhane distillé dans un deuxième ballon purgé trois fois vide argon. La solution de tetrabromométhane a alors été ajoutée goutte-à-goutte à 0°C à la solution triphénylphosphine. Le mélange résultant, s'est coloré en orange vif, est a été laissé sous agitation pendant 15 min.

1,5 g (9 mmol) de 3,5-diméthoxybenzaldéhyde ont été solubilisés avec 20 ml dichlorométhane distillé dans un ballon purgé trois fois vide/argon. Cette solution a alors été ajoutée à la précédente, puis le mélange a ainsi été laissé sous agitation pour 2 heures à température ambiante. Le milieu réactionnel a ensuite été agité avec de l'eau puis extrait trois fois avec 50 ml de dichlorométhane. La phase organique a alors été séchée sur sulfate de sodium puis le solvant a été évaporé sous pression réduite. Le brut de la réaction a ensuite été purifié par chromatographie sur colonne en utilisant comme éluant un mélange éther de pétrole / dichlorométhane 7/3, v/v). Le produit a alors été isolé sous la forme d'un solide transparent (m = 2,02 g, rendement 70%).

RMN $^1H$ (400 MHz, $CD_3CN$) δ 7,42 (s, 1H) ; 6,69 (dd, *J* = 2,3 ; 0,5 Hz, 2H) ; 6,45 (t, *J* = 2,3 Hz, 1H) ; 3,80 (s, 6H). Ce spectre est en accord avec ceux précédents publiés par W.H. Moser et al., J. Org. Chem., 2006, 71(17), 6542-6546.

1) Deuxième étape : Synthèse du 1-éthynyl-3,5-diméthoxy-benzène (**8**)

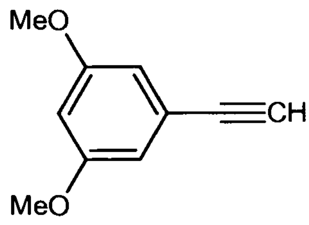

(8)

2,02 g (6,3mmol) de composé (7) obtenu ci-dessus à l'étape précédente ont été déposés dans un ballon puis purgé trois fois vide/argon. Le solide a alors été solubilisé dans du THF et refroidi à -78°C. On a ensuite ajouté 19,6 ml d'une solution de butyl-lithium à 1,4 M dans l'hexane. Le mélange a été laissé sous agitation à -78°C pendant 1 heure puis à -40°C pendant 2 heures. Le mélange a ensuite été ramené à température ambiante, l'excès de butyl-lithium a été neutralisé avec 5 ml de méthanol, puis le milieu réactionnel a été agité avec de l'eau et extrait trois fois avec 50 ml de dichlorométhane. La phase organique a alors été séchée sur sulfate de sodium puis le solvant a été évaporé sous pression réduite. On a obtenu le produit attendu sous la forme d'une poudre jaune (m = 1,07 g, rendement = 99 %).

RMN $^1H$ (400 MHz, $CDCl_3$) $\delta$ 6,65 (s, 2H) ; 6,47 (s, 1H) ; 3,78 (s, 6H) ; 3,04 (s, 1H). Ce spectre est en accord avec celui donné par J. Kalisiak, et al., Org. Lett., 2008, 10(15), 3171-3174.

<u>3) Troisième étape : Synthèse du bis(3,5-diméthoxy-benzène)acétylène (**9**)</u>

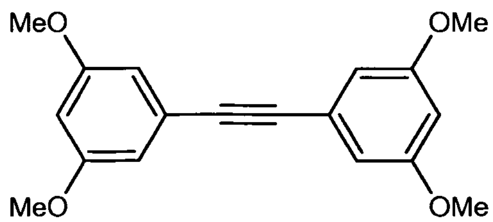

(9)

810 mg (5 mmol) du composé (**8**) obtenu ci-dessus à l'étape précédente, 1,09 mg (5 mmol) de 3,5-diméthoxy-iodobenzène, 10 mg (50 $\mu$mol) de iodure cuivrique et 35 mg (50 $\mu$mol) de chlorure de bis(triphénylphosphine)palladium(II) ont été ajoutés dans un ballon. Le ballon a alors été purgé 3 fois avec de l'argon. 40 ml de triéthylamine distillée ont alors été ajoutés et le mélange a ensuite été agité pendant 24 heures. Le milieu réactionnel a alors été dilué avec 60 ml d'une solution d'acide chlorhydrique 6 M puis extrait trois fois avec 50 ml de dichlorométhane. La phase organique a été lavée avec 100 ml de solution de soude 1 M, puis séchée sur sulfate de sodium et le solvant a été évaporé sous pression réduite. Le brut de la réaction a ensuite été purifié par chromatographie sur colonne en utilisant comme éluant un mélange éther de pétrole/dichlorométhane : 1/1, v/v). Le produit attendu a alors été isolé sous la forme d'une poudre jaune (m = 0,99 g, rendement = 66 %).

RMN $^1H$ (400 MHz, $CDCl_3$) $\delta$ 6,70 (d, *J* = 2,3 Hz, 4H) ; 6,47 (t, *J* = 2.3 Hz, 2H) ; 3,81 (s, 12H). Ce spectre était en accord avec ceux précédemment obtenus par Y.T. Wu et al., Angew. Chem. Int. Ed., 2008, 47(51), 9891-9894.

<u>4) Quatrième étape : Synthèse du [1,1',1",1"'-($\eta$4-1,3-cyclobutadiène-1,2,3,4-tetrayl)tetrakis[3,5 diméthoxy-benzène]]($\eta$5-cyclopentadiényl)-cobalt(I)</u>

Le protocole général de complexation/cyclisation [2+2] mis en oeuvre ci-dessus à l'exemple 4 a été appliqué ici sur 75 mg (0,25 mmol) du composé (**9**) obtenu ci-dessus à l'étape précédente et 56,3 mg (1,5 équivalent, 0,19 mmol) de composé (**3**) tel que préparé ci-dessus à l'étape 3) de l'exemple 1, pour donner le produit attendu sous forme d'une poudre jaune (90 mg, rendement 99 %).

RMN $^1H$ (400 MHz, $CDCl_3$) $\delta$ 6,71 (d, *J* = 2,2 Hz, 8H) ; 6,35 (t, *J* = 2,2 Hz, 4H) ; 4,67 (s, 5H) ; 3,68 (s, 12H).

RMN $^{13}C$ (101 MHz, $CDCl_3$) $\delta$ 160,14 ; 138,19 ; 107,09 ; 99,20 ; 83,28 ; 75,06 ; 55,25.

**EXEMPLE 7**

**Synthèse du [1,1'-[(1,2,3,4-η)-2,4-bis(4-méthoxybenzène)-1,3-cyclobutadièn-1,3-diyl]bis [phényl] ](η5-2,4-cyclopentadièn-1-yl)-cobalt(I)**

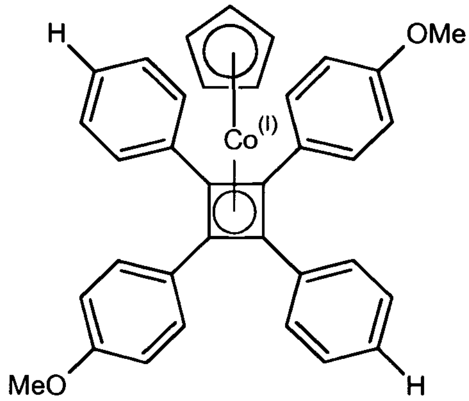

1) Première étape : Synthèse du 1-méthoxy-4-phényléthynyl-benzène (**10**)

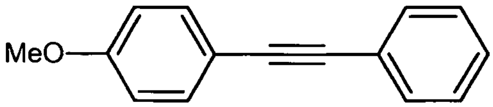

**(10)**

112 mg (1,1 mmol) d'éthynyl-benzène, 259 mg (1,1 mmol) de 4-méthoxy-iodobenzène, 2 mg (10 μmol) de iodure cuivrique et 8 mg (10 μmol) de chlorure de bis(triphénylphosphine)palladium(II) ont été ajoutés dans un ballon. Le ballon a alors été purgé 3 fois avec de l'argon. 20 ml de triéthylamine distillée ont été ajoutés et le mélange a alors été agité pendant 24 heures. Le milieu réactionnel a alors été dilué avec 20 ml d'une solution d'acide chlorhydrique 6 M puis extrait trois fois avec 20 ml de dichlorométhane. La phase organique a été lavée avec 40 ml d'une solution de soude 1M, puis séchée sur sulfate de sodium et le solvant a été évaporé sous pression réduite. Le brut de la réaction a ensuite été purifié par chromatographie sur colonne en utilisant comme éluant un mélange éther de pétrole dichlorométhane (7/3 ; v/v). Le produit attendu a alors été isolé sous la forme d'une poudre jaune (m = 201 mg, rendement = 97 %).

RMN $^1H$ (400 MHz, $CDCl_3$) δ 7,51 (d, *J* = 7,8Hz, 2H) ; 7,47 (d, *J* = 8,9 Hz, 2H) ; 7,33 (m, 3H) ; 6,88 (d, *J* = 8,9 Hz, 2H) ; 3,83 (s, 3H). Ce spectre était en accord avec celui obtenu par B. H. Lipshutz et al., Organic Letters, 2008, 10(17), 3793-3796.

2) Deuxième étape : Synthèse du [1,1'-[(1,2,3,4-η)-2,4-bis(4-méthoxybenzène)-1,3-cyclobutadièn-1,3-diyl]bis[phényl]](η5-2,4-cyclopentadièn-1-yl)-cobalt(I)

Le protocole général de complexation/cyclisation [2+2] mis en oeuvre ci-dessus à l'exemple 4 a été ici appliqué sur 21 mg (0,1 mmol) composé (**10**) obtenu ci-dessus à l'étape précédente et 23 mg (1,5 équivalent, 75μmol) de composé (3) tel que préparé ci-dessus à l'étape 3) de l'exemple 1, pour donner le produit attendu sous forme d'une poudre jaune (27 mg, rendement 99 %).

RMN $^1H$ (400 MHz, $C_6D_6$) δ 7,78 (d, *J* = 6,2 Hz, 4H) ; 7,67 (d, *J* = 8.2 Hz, 4H), 7.19 (m, 6H), 6.79 (d, *J* = 8.7 Hz, 4H), 4.68 (s, 5H), 3.41 (s, 6H).

RMN $^{13}C$ (101 MHz, $CDCl_3$) δ 157,99 ; 136,91 ; 130,13 ; 129,98 ; 128,75 ; 128,60 ; 127,88 ; 125,95 ; 113,48 ; 82,98 ; 55,20 ; 29,70.

**EXEMPLE 8**

**Synthèse du [1,1'-[(1,2,3,4-η)-2,4-bis(4-nitrobenzène)-1,3-cyclobutadièn-1,3-diyl]bis[phényl]](η5-2,4-cyclopentadièn-1-yl)-cobalt(I)**

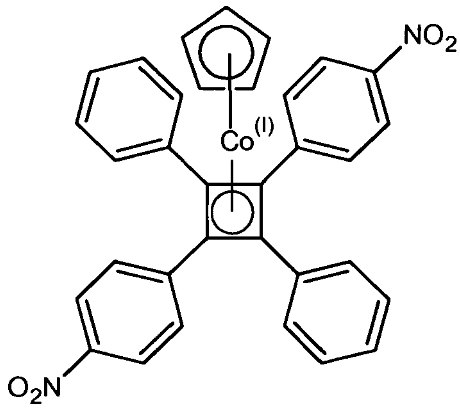

1) Première étape : Synthèse du 1-nitro-4-phényléthynyl-benzène

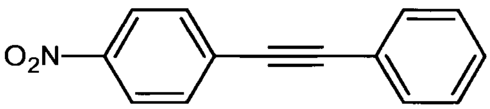

**(11)**

112 mg (1,1 mmol) d'éthynyl-benzène, 274 mg (1,1 mmol) de 4-nitro-iodobenzène, 2 mg (10 μmol) de iodure cuivrique et 8 mg (10 μmol) de chlorure de bis(triphénylphosphine)palladium(II) ont été ajoutés dans un ballon. Le ballon a alors été purgé 3 fois avec de l'argon. 20 ml de triéthylamine distillée ont été ajoutés et le mélange a alors été agité pendant 24 heures. Le milieu réactionnel a alors été dilué avec 20 ml d'une solution d'acide chlorhydrique 6M puis extrait trois fois avec 20 ml de dichlorométhane. La phase organique a été lavée avec 40 ml d'une solution de soude 1M, puis séchée sur sulfate de sodium et le solvant a été évaporé sous pression réduite. Le brut de la réaction a ensuite été purifié par chromatographie sur colonne en utilisant comme éluant un mélange éther de pétrole/dichlorométhane (8/2 ; v/v). Le produit (**11**) attendu a alors été isolé sous la forme d'une poudre jaune (m = 217 mg, rendement = 88 %).

RMN $^1H$ (400 MHz, $CDCl_3$) δ 8,25 (d, *J* = 9,0 Hz, 2H) ; 7,70 (d, *J* = 9,0 Hz, 2H) ; 7,62 - 7,56 (m, 2H), 7,45 - 7, 40 (m, 3H). Ce spectre était en accord avec celui précédemment obtenu par T. Mino et al., J. Org. Chem., 2006, 71(25), 9499-9502.

2) Deuxième étape : Synthèse du [1,1'-[(1,2,3,4-η)-2,4-bis(4-nitrobenzène)-1,3-cyclobutadièn-1,3-diyl]bis[phényl]](η5-2, 4-cyclopentadièn-1-yl)-cobalt(I)

Le protocole général de complexation/cyclisation [2+2], a été ici appliqué sur 23 mg (0.1mmol) du composé (**11**) obtenu ci-dessus à l'étape précédente et 23 mg du composé (3) (1,5 équivalent, 75μmol) obtenu à l'issue de l' étape 3) de l'exemple 1. Le produit brut a ensuite été purifié par chromatographie en utilisant comme éluant un mélange éther de pétrole/dichlorométhane (1/1, v/v). Le produit attendu a alors été isolé sous la forme d'une poudre rouge (m = 27 mg, rendement = 94 %).

RMN $^1H$ (400 MHz, $CDCl_3$) δ 8,05 (d, *J* = 9,0 Hz, 4H) ; 7,53 (d, *J* = 8,1 Hz, 4H) ; 7,48 (d, *J* = 9,0 Hz, 4H) ; 7, 45 - 7,36 (m, 6H) ; 4,72 (s, 5H).

RMN $^{13}C$ (101 MHz, $CDCl_3$) δ 145,56 ; 145,21 ; 134,10 ; 129,62 ; 128,90 ; 128,40 ; 127,97 ; 127,58 ; 83,63 ; 71,86 ; 29.72.

Le spectre d'absorption de ce composé a été mesuré avec un spectrophotomètre UV-Visible vendu par la société Perkin Elmer sous la référence Lambda 650, en solution à 0,1 mmol/ml dans le dichlorométhane. Il est reporté

sur la figure 2 annexée sur laquelle l'absorbance en unités arbitraires est fonction de la longueur d'ondes en nm ($\lambda_{max}$ = 388 nm ; $\varepsilon$ = $4,1.10^4$ $cm^{-1}.L.mol^{-1}$ ; Egap = 2,3 eV).

**EXEMPLE 9**

**Synthèse du [1,1'-[(1,2,3,4-η)-2,4-bis(4-nitrobenzène)-1,3-cyclobutadièn-1,3-diyl]bis 4-méthoxy-benzène]](η5-2, 4-cyctopentadièn-1-yl)-cobalt(I)**

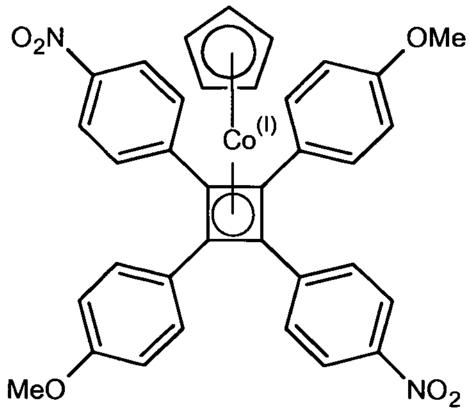

1) Première étape : Synthèse du 1-nitro-4-(4-méthoxy-éthynylbenzène)-benzène

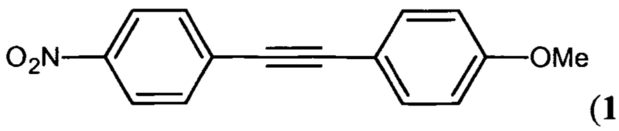

**(12)**

500 mg (3,8 mmol) du composé (**10**) tel que préparé ci-dessus à l'étape 1) de l'exemple 7, 940 mg (3,8 mmol) de 4-nitro-iodobenzène, 8 mg (38 μmol) de iodure cuivrique et 30 mg (38 μmol) de chlorure de bis(triphénylphosphine)palladium(II) ont été ajoutés dans un ballon. Le ballon a alors été purgé 3 fois avec de l'argon. 40 ml de triéthylamine distillée ont été ajoutés et le mélange a alors été agité pour 24 heures. Le milieu réactionnel a alors été dilué avec 60 ml d'une solution d'acide chlorhydrique 6M puis extrait trois fois avec 50 ml de dichlorométhane. La phase organique a été lavée avec 100 ml d'une solution de soude 1M, puis séchée sur sulfate de sodium et le solvant a été évaporé sous pression réduite. Le produit attendu a été obtenu sous forme d'une poudre jaune (m = 98 mg, rendement = 99 %).

RMN $^1H$ (400 MHz, $CDCl_3$) $\delta$ 8,18 (d, *J* = 9,0 Hz, 2H) ; 7,61 (d, *J* = 9,0 Hz, 2H) ; 7,49 (d, *J* = 8,9 Hz, 2H) ; 6,90 (d, *J* = 8,9 Hz, 2H) ; 3,83 (s, 3H).

RMN $^{13}C$ (101 MHz, $CDCl_3$) $\delta$ 160,44 ; 146,67 ; 133,44 ; 131,97 ; 130,68 ; 123,60 ; 114,22 ; 114,12 ; 95,17 ; 86,66 ; 55,36. Ce spectre est en accord celui précédemment obtenu par Y. Nishihara et al., Tet. Lett., 2009, 50(32), 4643-4646.

2) Deuxième étape : Synthèse du [1,1'-[(1,2,3,4-η)-2,4-bis(4-nitrobenzène)-1,3-cyclobutadièn-1,3-diyl]bis[4-méthoxy-benzène]](η5-2,4-cyclopentadièn-1-yl)-cobalt(I)

Le protocole général de complexation/cyclisation [2+2], a été ici appliqué sur 63 mg (0,25 mmol) du composé (**12**) obtenu ci-dessus à l'étape précédente et 56 mg du composé (**3**) tel qu'obtenu ci-dessus à l'étape 3) de l'exemple 1 (1,5 équivalent, 190 μmol). Le produit brut a ensuite été purifié par chromatographie en utilisation comme éluant un mélange éther de pétrole/dichlorométane (1/1 ; v/v). Le produit attendu a alors été isolé sous la forme d'une poudre rouge (m = 74mg, rendement = 95 %).

RMN $^1H$ (400 MHz, $CDCl_3$) $\delta$ 8,03 (d, *J* = 8,5 Hz, 4H) ; 7,47 (dd, *J* = 8,4, 6,4 Hz, 8H) ; 6,92 (d, *J* = 8,5 Hz, 4H) ; 4,68 (s, 5H) ; 3,90 (s, 6H).

RMN $^{13}C$ (101 MHz, $CDCl_3$) δ 159,01 ; 145,77 ; 145,42 ; 130,95 ; 127,65 ; 125,74 ; 123,49, 114,07 ; 83,39 ; 77,21 ; 72,11 ; 55,35.

Le spectre d'absorption de ce composé a été mesuré avec un spectrophotomètre UV-Visible vendu par la société Perkin Elmer sous la référence Lambda 650, en solution à 0,1 mmol/ml dans le dichlorométhane. Il est reporté sur la figure 3 annexée sur laquelle l'absorbance en unités arbitraires est fonction de la longueur d'ondes en nm ($\lambda_{max}$ = 396 nm ; ε = $3,4.10^4$ $cm^{-1}.L.mol^{-1}$ ; Egap = 2,1 eV).

**EXEMPLE 10**

**Synthèse du [1,1'-[(1,2,3,4-η)-2,4-bis(4-bromobenzène)-1,3-cyclobutadièn-1,3-diyl]bis[4-méthoxy-benzène]](η5-2,4-cyclopentadièn-1-yl)-cobalt(I)**

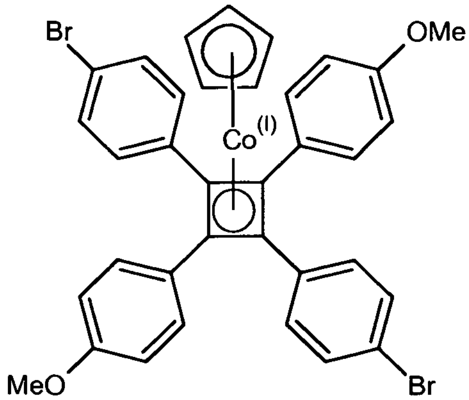

1) Première étape : Synthèse du 1-méthoxy-4-(4-bromo-éthynylbenzène)-benzène

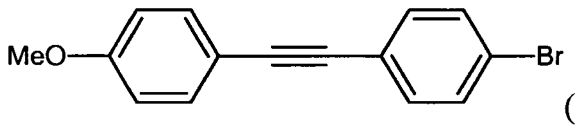

**(13)**

200 mg (1,1 mmol) du composé (**10**) tel que préparé ci-dessus à l'étape 1) de l'exemple 7, 259 mg (1,1 mmol) de 4-méthoxy-iodobenzène, 2 mg (10 μmol) de iodure cuivrique et 8 mg (10 μmol) de chlorure de bis(triphénylphosphine)palladium(II) ont été ajoutés dans un ballon. Le ballon a alors été purgé 3 fois avec de l'argon. 20 ml de triéthylamine distillée ont été ajoutés et le mélange a alors été agité pendant 24 h. Le milieu réactionnel a alors été dilué avec 20 ml d'une solution d'acide chlorhydrique 6M puis extrait trois fois avec 20 ml de dichlorométhane. La phase organique a été lavée avec 40 ml d'une solution de soude 1M, puis séchée sur sulfate de sodium et le solvant a été évaporé sous pression réduite. Le produit brut de la réaction a ensuite été purifié par chromatographie sur colonne en utilisant comme éluant un mélange éther de pétrole/dichlorométhane (1/1 ; v/v). Le produit attendu a alors été isolé sous la forme d'une poudre jaune (m = 287 mg, rendement = 99 %).

RMN $^1H$ (400 MHz, $CD_3CN$) δ 7,50 - 7,42 (d+d *J* = 8,9, 8,4 Hz, 4H) ; 7,36 (d, *J* = 8,4 Hz, 2H) ; 6,88 (d, *J* = Hz, 2H) ; 3,83 (s, 3H). Ce spectre est en accord celui précédemment obtenu par G.W. Kabalka, et al., Tet. Lett., 2006, 47(7), 1133-1136.

**EXEMPLE 11**

**Synthèse du [1,1',1",1"'-(η4-1,3-cyclobutadiène-1,2,3,4-tetrayl)tetrakis[4-benzoate de méthyl]](η5-cyclopentadiényl)-cobalt(I)**

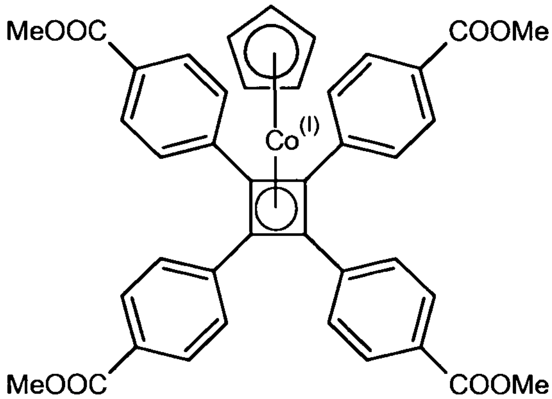

1) Première étape : Synthèse du diméthyl 4,4'-éthyne-1,2-diyldibenzoate

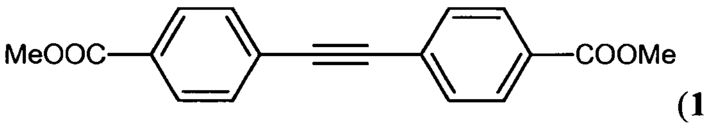

**(14)**

1 g (3,8 mmol) de méthyl ester de l'acide 4-iodo-benzoïque, 72 mg (0,39 mmol) de iodure cuivrique et 154 mg (0,22 mmol) de chlorure de bis(triphénylphosphine)palladium(II) ont été ajoutés dans un ballon. Le ballon a alors été purgé 3 fois avec de l'argon. 80 ml de benzène distillé, 4 g (26,6 mmol) de 1,8-diazabicyclo[5.4.0]undec-7-ène, 0,2 g (1,9 mmol) de triméthyl-silyl-acétylène et 22 μl (1,5 mmol) d'eau ont été ajoutés et le mélange a alors été agité pendant 24 heures dans l'obscurité. Le milieu réactionnel a alors été dilué avec 20 ml d'une solution d'acide chlorhydrique 6M puis extrait trois fois avec 20 ml de dichlorométhane. La phase organique a été lavée avec 40 ml d'une solution de soude 1 M, puis séchée sur sulfate de sodium et le solvant a été évaporé sous pression réduite. Le produit brut de la réaction a ensuite été purifié par chromatographie sur colonne en utilisant comme éluant un mélange éther de pétrole/acétate d'éthyle (3/1 ; v/v). Le produit attendu a alors été isolé sous la forme d'une poudre blanche (m = 394 mg, rendement = 72 %).

RMN $^1H$ (400 MHz, $CDCl_3$) δ 7,97 (d, *J* = 8,5 Hz, 1 H) ; 7,53 (d, *J* = 8,5 Hz, 1H) ; 3,86 (s, 2H).

Ce spectre était en accord avec celui obtenu précédemment par Y.T. Wu et al., Angew. Chem. Int., Ed. 2008, 47(51), 9891-9894.

2) Deuxième étape : Synthèse du [1,1',1'',1'''-(η4-1,3-cyclobutadiène-1,2,3,4-tetrayl)tetrakis[4-benzoate de méthyl]](η5-cyclopentadiényl)-cobalt(I)

Le protocole général de complexation/cyclisation [2+2], a été ici appliqué sur 100 mg (0,34 mmol) du composé (**14**) obtenu ci-dessus à l'étape précédente et 76 mg du composé (**3**) obtenu ci-dessus à l'étape 3) de l'exemple 1 (1,5 équivalent, 0,25 mmol), pour donner le produit attendu sous forme d'une poudre jaune (96 mg, rendement 80 %).

RMN $^1H$ (400 MHz, $CDCl_3$) δ 7,90 (d, *J* = 8,5 Hz, 8H) ; 7,46 (d, *J* = 8,5 Hz, 8H) ; 4,65 (s, 5H) ; 3,93 (s, 12H).

RMN $^{13}C$ (101 MHz, $CDCl_3$) δ 167,00 ; 141,20 ; 129,63 ; 128,68 ; 128,47 ; 83,86 ; 77,48 ; 77,16 ; 76,84 ; 74, 91 ; 52.31.

**EXEMPLE 12**

**Synthèse du [1,1',1'',1'''-(η4-1,3-cyclobutadiène-1,2,3,4-tetrayl)tetrakis[2,2', 5'-bithiophène]](η5-cyclopentadiényl)-cobalt(I)**

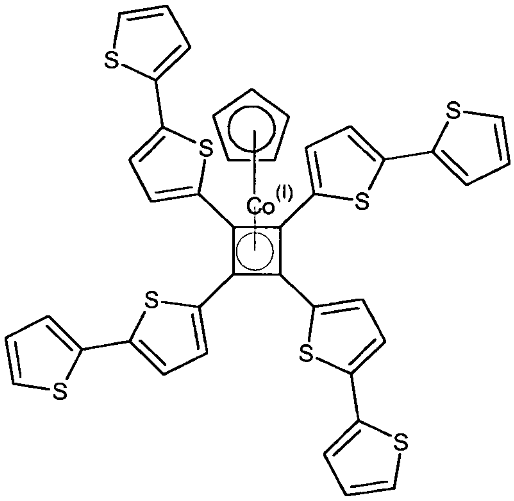

1) Première étape : Synthèse du 5-(2,2-dibromoéthényl)-2,2'-bithiophène

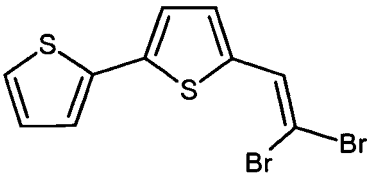

**(15)**

3,4 g (10,2 mmol) de tetrabromométhane ont été solubilisés avec 20 ml de dichlorométhane distillé dans un premier ballon purgé avec de l'argon. 5,4 g (20,4 mmol) de triphénylphosphine ont été solubilisés avec 20 ml de dichlorométhane distillé dans un deuxième ballon purgé trois fois avec de l'argon argon. La solution de tetrabromométhane a été ajoutée goutte-à-goutte à 0°C à la solution de triphénylphosphine. Le mélange résultant, s'est coloré en orange vif, est a été laissé sous agitation pendant 15 min.

Parallèlement 1 g (5,1 mmol) de 2-(carboxaldéhyde)-(5,2'-bithiophène) a été solubilisé avec 20 ml dichlorométhane distillé dans un ballon purgé trois fois avec de l'argon. Cette solution a alors été ajoutée au mélange de la solution de tetrabromométhane et de la solution de triphénylphosphine, puis le mélange résultant a ainsi été laissé sous agitation pendant 2 heures à température ambiante. Le milieu réactionnel a ensuite été agité avec de l'eau puis extrait trois fois avec 50 ml de dichlorométhane. La phase organique a alors été séchée sur sulfate de sodium puis le solvant a été évaporé sous pression réduite. Le produit brut de la réaction a ensuite été purifié par chromatographie sur colonne en utilisant du dichlorométhane comme éluant. Le produit (**15**) attendu a alors été isolé sous la forme d'un solide jaune (m = 1,55 g, rendement = 90 %).

RMN $^1$H : ($CDCl_3$ 400 MHz) : $\delta$ 7,03 (dd, 1H) ; 7,09 (d,1H) ; 7,13 (d,1H) ; 7,24 (d, 1H) ; 7,27 (d, 1H).

Ce spectre est en accord avec celui précédemment obtenu par T. B. Patrick et al., J. Org. Chem., 1974, 39(25), 3791-2.

2) Deuxième étape : Synthèse du 5-éthynyl-2,2'-bithiophène

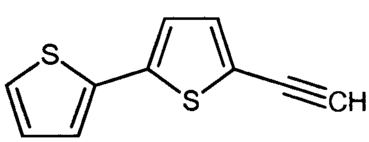

**(16)**

1,55 g (4,6 mmol) du composé (**15**) obtenu ci-dessus à l'étape précédente ont été déposés dans un ballon puis purgé trois fois avec de l'argon. Le solide a alors été solubilisé dans du THF et refroidi à -78°C. On a ensuite ajouté 3,68 ml d'une solution de butyl-lithium à 2,5M dans l'hexane. Le mélange a été laissé sous agitation à -78°C pendant 1 heure puis à -40°C pendant 2 heures. Le mélange a ensuite été ramené à température ambiante, l'excès de butyl-lithium a été neutralisé avec 5 ml de méthanol, puis le milieu réactionnel a été agité avec de l'eau et extrait trois fois avec 50 ml de dichlorométhane. La phase organique a alors été séchée sur sulfate de sodium puis le solvant a été évaporé sous pression réduite. Le brut de la réaction a ensuite été purifié par chromatographie sur colonne en utilisant de l'éther de pétrole comme éluant. On a obtenu le produit (**16**) attendu sous la forme d'un solide noir (m = 624 mg, rendement = 71 %).

RMN $^1H$ : ($CDCl_3$, 400 MHz) : $\delta$ 7,25 (dd *J* = 1,2 ; 5,1 Hz, 1 H) ; 7,19 (dd, *J* = 1,2 ; 3,6 Hz, 1H) ; 7,18 (dd, *J* = 0,5 ; 3,6 Hz, 1H) ; 7,01-7,04 (m, 2H) ; 3,40 (d, *J* = 0,5 Hz). Ce spectre est en accord avec celui précédemment obtenu par T. B. Patrick, et al., J. Org. Chem., 1974, 39(25), 3791-2.

3) Troisième étape : Synthèse du bis-2-(5,2'-bithiophène)acétylène

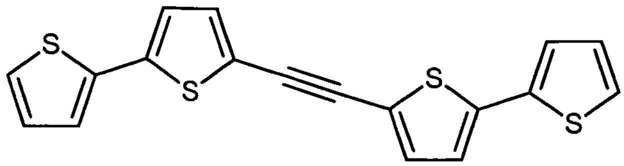

**(17)**

0,291 mg (1,5 mmol) du composé (**16**) obtenu ci-dessus à l'étape précédente, 444 mg (1,5 mmol) de 2-iodo-(5, 2'-bithiophène), 3 mg (15 $\mu$mol) de iodure cuivrique et 11 mg (15 $\mu$mol) de chlorure de bis-(triphénylphosphine)palladium(II) ont été ajoutés dans un ballon. Le ballon a alors été purgé 3 fois avec de l'argon. 40 ml de triéthylamine distillée ont été ajoutés et le mélange a alors été agité pendant 24 heures. Le milieu réactionnel a alors été dilué avec 60 ml d' une solution d'acide chlorhydrique 6M puis extrait trois fois avec 50 ml de dichlorométhane. La phase organique a été lavée avec 100 ml d'une solution de soude 1 M, puis séchée sur sulfate de sodium et le solvant a été évaporé sous pression réduite. Le brut de la réaction a ensuite été purifié par chromatographie sur colonne (éluant éther de pétrole). Le produit (**17**) attendu a alors été isolé sous la forme d'une poudre jaune (m = 512g, rendement = 96 %).

RMN $^1H$ (400 MHz, $CDCl_3$) $\delta$ 7,25 (d, *J* = 5,1Hz, 2H) ; 7,20 (d, *J* = 3,6 Hz, 2H) ; 7,18 (d, *J* = 3,8 Hz, 2H) ; 7,07 (d, *J* = 3,8 Hz, 2H) ; 7,20 (dd, *J* = 5,1 ; 3,6 Hz, 2H). Ce spectre est en accord avec celui précédemment obtenu par J. Nakayama et al., Heterocycles, 1992, 34(8), 1487-90.

4) Quatrième étape : Synthèse du [1,1',1",1'"-($\eta$4-1,3-cyclobutadiène-1,2,3,4-tetrayl)tetrakis[2,2',5'-bithiophène]]($\eta$5-cyclopentadiényl)-cobalt(I)

Le protocole général de complexation/cyclisation [2+2], a été ici appliqué sur 51 mg (0,145 mmol) du composé (**17**) obtenu ci-dessus à l'étape précédente et 28 mg du composé (3) obtenu ci-dessus à l'étape 3) de l'exemple 1 (1,5 équivalent, 0,11 mmol), pour donner le produit attendu sous forme d'une poudre noire (53 mg, 83%).

RMN $^1H$ (400 MHz, CDCl3) $\delta$ 7,26 (m, 4H), 7,10 (d, *J* = 3,7, 4H) ; 7,05 - 7,00 (m, 8H) ; 4,85 (s, 5H).

Le spectre d'absorption de ce composé a été mesuré avec un spectrophotomètre UV-Visible vendu par la société Perkin Elmer sous la référence Lambda 650, en solution à 0,24 mmol/ml dans le dichlorométhane. Il est reporté sur la figure 4 annexée sur laquelle l'absorbance en unités arbitraires est fonction de la longueur d'ondes en nm ($\lambda_{max}$ = 354 nm ; $\varepsilon$ = 5,1.10$^4$ cm$^{-}$1.L.mor$^{-1}$ ; Egap = 2,0 eV).

## EXEMPLE 13

### Préparation de cellules de conversion photovoltaïque et études de leurs propriétés

Différentes cellules de conversion photovoltaïques mettant en oeuvre différents composés de formule (I) ont été préparées. Le protocole général de préparation de ces cellules a été le suivant.

Une plaque de verre (25 x 23 mm) couverte d'une couche d'ITO à titre d'électrode positive (10-100 $\Omega$/sq, Sigma Aldrich) a été décapée partiellement avec une solution d'acide chlorhydrique à 18% en vol et de Fe($Cl_3$), à température ambiante pendant une minute. La plaque ainsi décapée a été lavée avec un agent nettoyant à base d'agents tensioactifs anioniques et non-ioniques, d'agents stabilisants, d'alcalis et d'agents séquestrants vendu sous la dénomination commerciale Decon 90 ® par la société DECON, puis avec de l'acétone (20 min, ultrason), de l'éthanol (20 min, ultrason), et sous irradiation UV/$O_3$ pendant 30 min.

Une couche de 20 nm de PEDOT:PSS a ensuite été déposée par voie humide (dépôt centrifuge, 22 $\mu$L d'une

solution à 4,05 mL de PEDOT:PSS dans 4,95 ml d'eau, puis le cas échéant recuit à 110°C pendant 30 min (voir tableau I) dans un four tubulaire sous flux d'azote). Une couche active de 80 nm a ensuite été déposée par voie humide à partir d'une solution comprenant un composé de formule (I) et du PCBM dans le 1,2-dichlorométhane pour les cellules n°4, 5 et 6 ou dans le chlorobenzène pour les cellules n°1, 2 et 3 (dépôt centrifuge, 150 s, 200 rpm, solutions à différents rapports massiques composé de formule (I)/PCBM). Un recuit de 30 min à 120°C a alors éventuellement été effectué dans un four tubulaire sous flux d'azote (voir Tableau I). Puis, une couche de 0,8 nm de LiF (couche tampon) et de 80 nm d'aluminium (électrode négative) ont été déposées par évaporation, dans une enceinte à ultravide.

Dans cet exemple les composés de formule (I) utilisés sont le [1,1',1",1"'-(η4-cyclobutadiène-1,2,3,4-tetrayl)tetrakis[2,2',5',2",5"-terthiophène]](η5-cyclopentadiényl)-cobalt(I) tel que préparé ci-dessus à l'exemple 1 et le [1,1'-[(1,2,3,4-η)-2,4-bis(4-nitrobenzène)-1,3-cyclobutadièn-1,3-diyl]bis[4-méthoxy-benzène]](η5-2,4-cyclopentadièn-1-yl)-cobalt(I) tels que préparé ci-dessus à l'exemple 9.

Les différentes cellules préparées sont détaillées dans le Tableau 1 ci-après :

**TABLEAU 1**

| Cellule | Composé de formule (I) | Ratio massique Composé (I) / PCBM | Concentration de la solution de couche active (mg/ml) | Vitesse de dépôt couche active | Recuit du PEDOT :PSS | Recuit de la couche active |
|---|---|---|---|---|---|---|
| **1** | Ex. 9 | 1/1 | 30 | 1000 rpm / 50 s | oui | non |
| **2** | Ex. 1 | 1/1 | 30 | 500 rpm / 30 s | oui | non |
| **3** | Ex. 1 | 1/1 | 30 | 500 rpm / 50 s | oui | oui |
| **4** | Ex. 1 | 1/2 | 25 | 200 rpm / 150 s | oui | non |
| **5** | Ex. 1 | 1/4 | 40 | 200 rpm / 150 s | oui | non |
| **6** | Ex. 1 | 1/2 | 15 | 200 rpm / 150 s | non | non |

Ces différentes cellules ont ensuite été testées en conversion photovoltaïque sur une station micro-pointe, sous un éclairement AM 1,5 d'un simulateur de rayonnement solaire équipé d'une lampe Xenon de 150 W, vendu par la société Lot Oriel. Les mesures ont été effectuées avec une station micropoint couplée à un sourcemètre (Keithley 2602 SourceMetre).

La surface standard des électrodes était comprise entre 0,03 $mm^2$ et 0,15 $mm^2$ et la puissance surfacique incidente était de 75 ou 100 $mW/cm^2$.

Pour chaque cellule, une courbe courant tension (I = f(V)) a été faite dans le noir et sous illumination (non représentée).

Le facteur de forme (FF) a été calculé selon la formule suivante :

$$FF = \frac{P\max}{P\max_{abs}} = \frac{Ipm \times Vpm}{Isc \times Voc}$$

dans laquelle :

Pmax = Puissance maximale mesurée

$Pmax_{abs}$ = Puissance maximale absolue

$I_{pm}$ = Intensité à la puissance maximale

Vpm = Tension à la puissance maximale

$I_{sc}$ = Intensité de court circuit

$V_{oc}$ = Tension de court circuit

Le rendement ($\eta$) de chacune des cellules a été calculé selon la formule suivante :

$$\eta = \frac{P\max}{Pi} = \frac{Ipm \times Vpm}{Pis \times S} = \frac{FF \times Isc \times Voc}{Pis \times S}$$

dans laquelle :

Pi = Puissance incidente
Pis = Puissance surfacique incidente
S = Surface de l'électrode

Les performances de chacune des cellules sont données dans le Tableau 2 ci-après :

**TABLEAU 2**

| Cellule | $V_{oc}$ (mV) | Rendement de conversion photovoltaïque (%) | FF (%) |
|---|---|---|---|
| **1** | 403 | 0,005 | 26 |
| **2** | 659 | 0,15 | 25 |
| **3** | 670 | 0,17 | 30 |
| **4** | 523 | 0,17 | 26 |
| **5** | 483 | 0,16 | 28 |
| **6** | 608 | 0,35 | 30 |

Les valeurs données dans le Tableau 2 ci-dessus sont tirées du cadran 4 des courbes I= f(V) (quart inférieur droit, abscisses > 0 et ordonnées < 0).

Ces résultats montrent que les cellules de conversion photovoltaïques présentent un $V_{oc}$ pouvant atteindre 600 mV, ce qui est comparable à ce qui est obtenu avec les cellules les plus performantes actuellement dans la littérature actuelle (cellule Konarka P3HT/PCBM : $V_{oc}$ < 650 mV ; C.J. Brabec et al., Adv. Mater., 2009, 21, 1323-1338).

Le $V_{oc}$ est un marqueur de l'ajustement des niveaux électroniques entre le donneur d'électron (composé de formule (I)) et l'accepteur d'électrons (ici le PCBM). La présence du coeur cobalt joue un grand rôle dans ce bon positionnement des niveaux électroniques des composés de formule (I). Ces résultats sont très surprenants dans la mesure où les meilleurs rendements de conversion sont obtenus avec les cellules préparées sans recuit, ce qui est contraire à l'enseignement de la littérature.

**EXEMPLE 14**

**<u>Préparation de deux cellules de conversion photovoltaïque conforme à l'invention</u>**

Dans cet exemple, on a préparé et testé deux cellules de conversion photovoltaïque ayant des tailles d'électrodes différentes, en utilisant dans la couche active le composé synthétisé ci-dessus à l'exemple 1 comme donneur d' électron et du PCBM à titre d'accepteur d'électrons.

Le protocole général de préparation des cellules photovoltaïques donné ci-dessus à l'exemple 13 a été utilisé, avec les spécificités suivantes :

- toutes les étapes de fabrication et de test de la cellule ont été effectuées en boite à gant en atmosphère inerte ($N_2$).

- Dépôt d'une couche de 20 nm PEDOT :PSS (22 $\mu$l, dépôt d'une goutte de la solution, puis enduction centrifuge à 2000 rpm pendant 50 s, sans recuit) ;

- Dépôt d'une couche active de 100 nm à partir d'une solution du composé synthétisé à l'exemple 1 (10 mg) et de PCBM (20 mg) dans le dichlorométhane, ladite solution ayant été soumise à des ultrasons pendant 20 min et filtré sur filtre de PTFE 0,2 $\mu$m (17 $\mu$l de solution, dépôt d'une goutte de solution sur l'échantillon, puis enduction centrifuge

à 350 rpm pendant 200 s puis 2000 rpm pendant 5s, pas de recuit) ;

- Dépôt de LiF par voie gazeuse : évaporation de 8 Å de LiF ;
- Dépôt d'aluminium par voie gazeuse : évaporation de 80 nm d'Al

La cellule n° 7 a été préparée selon ce protocole en utilisant des électrodes de 7,5 $mm^2$ et une puissance incidente de 75 mW et la cellule n° 8 en utilisant des électrodes de 5 $mm^2$ et une puissance incidente de 100 mW.

Les courbes obtenues I (en ampère) = f(V) (en volt) pour chacune des cellules sont données respectivement par les figures 5 et 6 annexées.

Sur la figure 5, la courbe la plus basse correspond à la caractéristique courant-tension sous illumination et la courbe la plus haute correspond à la caractéristique courant-tension dans le noir. Sur la figure 6, la courbe tracée avec les ronds vides (o) correspond à la caractéristique courant-tension sous illumination et la courbe tracée avec les signes (+) correspond à la caractéristique courant-tension dans le noir.Les performances de chacune de ces cellules sont reportées dans le Tableau 3 ci-après :

**TABLEAU 3**

| Cellule | $I_{sc}$ (mA) | $J_{sc}$ (mA/$cm^2$ | $V_{oc}$ (mV) | FF (%) | η (%) |
|---|---|---|---|---|---|
| **7** | -0,254 | 3,38 | 739 | 29,2 | 0,98 |
| **8** | -0,241 | 4,87 | 737 | 31,3 | 1,11 |

Ces résultats démontrent les très bonnes performances des cellules photovoltaïques conformes à l'invention. En effet, les meilleures cellules de conversion photovoltaïques connues à l'heure actuelle dans lesquelles la couche active est composée d'un composé de type p (ici composé de formule (I)) et d'un composé de type n (ici PCBM), qui sont tous les deux des « petites » molécules, c'est-à-dire des composés non polymériques, conduisent généralement à un rendement maximum inférieur à 1 %.

## Revendications

**1.** Utilisation d'au moins un complexe de cobalt de formules(I-a) ou (I-b) suivante :

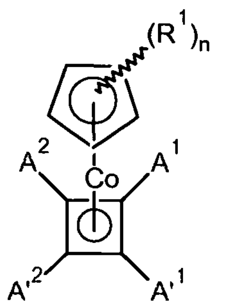

(I-a)

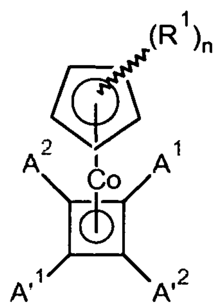

(I-b)

dans lesquelles :

- n est un entier variant de 0 à 5 ;
- $R^1$ est choisi parmi I, alkyle en $C_1$-$C_{12}$, triméthylsilyle, HgCl, -C(O)alkyle en $C_1$-$C_4$, et un groupement oxazole éventuellement substitué par un radical alkyle en $C_1$-$C_4$, étant entendu que lorsque n>1, tous les radicaux $R^1$ d'un composé de formule (I-a) ou (1-b) donné sont identiques,
- les groupements $A^1$, $A'^1$, $A^2$ et $A'^2$ sont identiques deux à deux et choisis parmi les groupements de formules (II-1) à (II-9) suivantes :

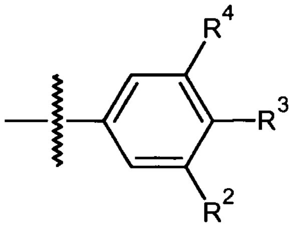 (II-1) 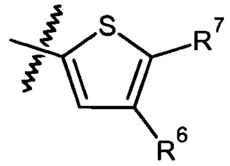 (II-2)

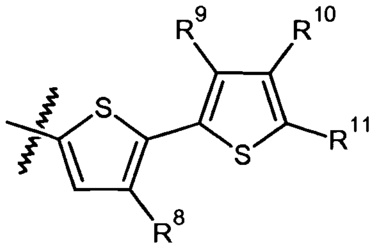 (II-3) 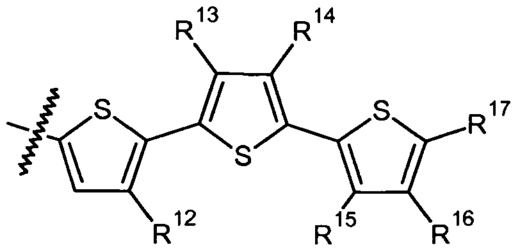 (II-4)

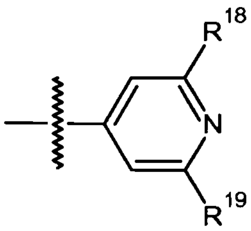 (II-5) 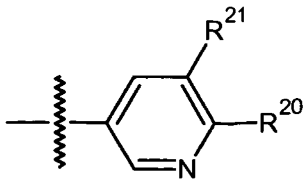 (II-6)

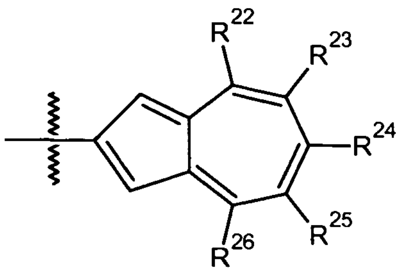 (II-7)

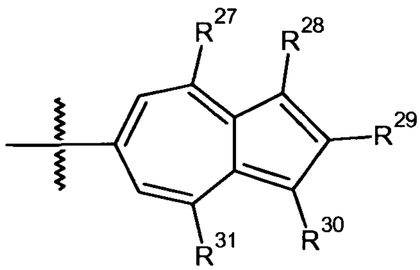 (II-8)

et

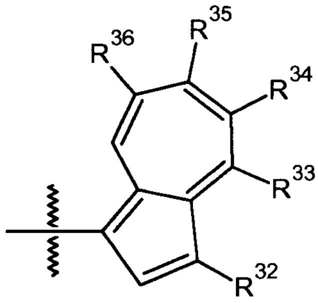

(II-9)

dans lesquels :

- $R^2$, $R^3$, et $R^4$, identiques ou différents, représentent un atome d'hydrogène, d'iode ou de brome, un radical nitro, alkyle linéaire en $C_1$-$C_{12}$, trifluorométhyle, dialkyl($C_1$-$C_4$)amino, -C(O)alkyle en $C_1$-$C_4$ ou alcoxy linéaire en $C_1$-$C_4$ ;
- $R^6$, $R^8$, $R^9$, $R^{10}$, $R^{12}$, $R^{13}$, $R^{14}$, $R^{15}$ et $R^{16}$, identiques ou différents, représentent un atome d'hydrogène ou de brome, un radical alkyle linéaire en $C_1$-$C_{12}$ ou alcoxy linéaire en $C_1$-$C_4$, $R^9$ et $R^{10}$ ensemble et/ou $R^{13}$ et $R^{14}$ ensemble et/ou $R^{15}$ et $R^{16}$ ensemble peuvent également former un groupement éthylènedioxy (-O-$(CH_2)_2$-O-).
- $R^7$, $R^{11}$ et $R^{17}$, représentent un atome d'hydrogène, de brome ou d'iode, un radical nitro, alkyle linéaire en $C_1$-$C_{12}$, alcoxy linéaire en $C_1$-$C_4$, -CHO, -C(O)alkyle en $C_1$-$C_4$, -C(O)alcoxy en $C_1$-$C_4$ ou un cycle thiophène portant éventuellement un ou plusieurs substituants choisis parmi Br, I, nitro, alkyle linéaire en $C_1$-$C_{12}$, alcoxy linéaire en $C_1$-$C_4$, -C(O)alkyle en $C_1$-$C_4$, et -C(O)alcoxy en $C_1$-$C_4$ ;
- $R^{18}$ à $R^{36}$, identiques ou différents, représentent un atome d'hydrogène, un radical alcoxy linéaire en $C_1$-$C_4$, un radical nitro ou -C(O)alcoxy en $C_1$-$C_4$,

à titre de donneur d'électron, et en combinaison avec un accepteur d'électron, pour la préparation d'une couche active dans une cellule de conversion photovoltaïque.

2. Utilisation selon la revendication 1, **caractérisée en ce que** n est égal à 1 ou 2, et le ou les radicaux $R_1$ représente(nt) un radical méthyle.

3. Utilisation selon la revendication 1, **caractérisée en ce que** les complexes de formules (I-a) et (I-b) sont choisis parmi :

- le [1,1',1",1'"-(η4-1,3-cyclobutadiène-1,2,3,4-tetrayl)tetrakis-[benzène]] (η5-cyclopentadiényl)-cobalt(I) ;
- le [1,1',",1 1'"-(η4-1,3-cyclobutadiène-1,2,3,4-tetrayl)tetrakis-4-n-butyl-benzène]](η5-cyclopentadiényl)-cobalt(I) ;
- le [1,1',1",1'"-(η4-1,3-cyclobutadiéne-1,2,3,4-tetrayl)tetrakis-[3,5-diméthoxy-benzène]](η5-cyclopentadiényl)-cobalt(I) ;
- le [1,1'-[(1,2,3,4-η)-2,4-bis(4-méthoxybenzène)-1,3-cyclobutadién-1,3-diyl]bis[phényl]](η5-2,4-cyclopentadién-1-yl)-cobalt(I) ;
- le [1,1'-[(1,2,3,4-η)-2,4-bis(4-nitrobenzène)-1,3-cyclobutadién-1,3-diyl]bis[phényl]](η5-2,4-cyclopentadién-1-yl)-cobalt(I) ;
- le [1,1'-[(1,2,3,4-η)-2,4-bis(4-nitrobenzène)-1,3-cyclobutadièn-1,3-diyl]bis[4-méthoxy-benzène]](η5-2,4-cyclopentadién-1-yl)-cobalt(I) ;
- le [1,1'-[(1,2,3,4-η)-2,4-bis(4-bromobenzène)-1,3-cyclobutadièn-1,3-diyl]bis[4-méthoxy-benzène]](η5-2,4-cyclopentadièn-1-yl)-cobalt(I) ;
- le [1,1',1",1'"-(n4-1,3-cyclobutadiène-1,2,3,4-tetrayl)tetrakis-[4-benzoate de méthyl]](η5-cyclopentadiényl)-cobalt(I) ;
- le [1,1'1",1'"-(η4-1,3-cyclobutadiène-1,2,3,4-tetrayl)tetrakis-[2,2',5',bithiophène]]-(η5-cyclopentadiényl)-cobalt(I) ;
- le [1,1',1",1'"-(η4-1,3-cyclobutadiène-1,2,3,4-tetrayl)tetrakis[2,2',5',2",5"-ter-thiophène]](η5-cyclopentadiényl)-cobalt(I) ;
- le [1,1',1",1'"-(η4-cyclobutadiéne-tetrakis 1,2,3,4-[2,5,2',5',2"-terthiophène-5"-carbaldéhyde])]-(η5-cyclopentadiényl)-cobalt(I) ;
- le [1,1',1",1'"-(η4-cyclobutadiène-tetrakis 1,2,3,4-[2,5,2',5',2"-terthiophène-5"-bromo])]-(η5-cyclopentadiényl)-cobalt(I) ;
- le 1,1',1",1'"-(η4-cyclobutadiène-tetrakis 1,2,3,4-[2,5,2',5',2"-terthiophène-5"-méthoxy])]-(η5-cyclopentadiényl)-cobalt(I) ;

- le [1,1',1",1"'-(η4-cyclobutadiène-tetrakis 1,2,3,4-[2,5,2',5',2"-terthiophène-5"-nitro])]-(η5-cyclopentadiényl)-cobalt(I) ;
- le [1,1',1",1"'-(η4-cyclobutadiène-tetrakis 1,2,3,4-[2,5,2',5',2'-terthiophène-(4,4',4")-tris hexyl])]-(η5-cyclopentadiényl)-cobalt(I) ;
- le [1,1',1",1"'-(η4-cyclobutadiène-tetrakis 1,2,3,4-[2,5,2',5',2"-terthiophène-5"-dodécyl])]-(η5-cyclopentadiényl)-cobalt(I) ;
- le [1,1',1",1"'-(η4-cyclobutadiène-tetrakis 1,2,3,4-[2,5,2',5',2"-terthiophène-5"-iodo])]-(η5-cyclopentadiényl)-cobalt(I) ;
- le [1,1',1",1"'-(η4-cyclobutadiène-bis 1,3-[2,5,2',5',2"-ter-thiophène-5"-nitro], bis 2,4-[2,5,2',5',2"-terthiophène-5"-méthoxy])]-(η5-cyclopentadiényl)-cobalt(I) ;
- le [1,1',1",1'''-(η4-cyclobutadiène-bis 1,3-[2,5,2',5',2"-ter-thiophène-5"-bromo], bis 2,4-[2,5,2',5',2"-terthiophène-5"-méthoxy])]-(η5-cyclopentadiényl)-cobalt(I) ;
- le [1,1',1",1"'-(η4-1,3-cyclobutadiène-1,2,3,4-tetrayl)tetrakis-[2-thionyl]] (η5-cyclopentadiényl)-cobalt(I) ;
- le [1,1',1",1"'-(η4-1,3-cyclobutadiène-1,2,3,4-tetrayl)tetrakis-[3-pyridyl]] (η5-cyclopentadiényl)-cobalt(I) ;
- le [1,1',1",1"'-(η4-1,3-cyclobutadiène-1,2,3,4-tetrayl)tetrakis-[4-pyridyl]] (η5-cyclopentadiényl)-cobalt(I) ;
- le [1,1',1",1"'-(η4-1,3-cyclobutadiène-1,2,3,4-tetrayl)tetrakis-[1-azulényl]] (η5-cyclopentadiényl)-cobalt(I) ;
- le [1,1',1",1"'-(η4-1,3-cyclobutadiène-1,2,3,4-tetrayl)tetrakis-[2-azulényl]] (η5-cyclopentadiényl)-cobalt(I) ; et
- le [1,1',1",1"'-(η4-1,3-cyclobutadiène-1,2,3,4-tetrayl)tetrakis-[6-azulényl]] (η5-cyclopentadiényl)-cobalt(I).

4. Utilisation selon la revendication 1, **caractérisée en ce que** les complexes de formules (I-a) et (I-b) sont choisis parmi :

- le [1,1',",11'"-(η4-1,3-cyclobutadiéne-1,2,3,4-tetrayl)tetrakis-[2,2',5',bithiophène]]-(η5-cyclopentadiényl)-cobalt(I) ;
- le [1,1',1",1"'-(η4-1,3-cyclobutadiène-1,2,3,4-tetrayl)tetrakis[2,2',5',2",5"-ter-thiophène]](η5-cyclopentadiényl)-cobalt(I) ;
- le [1,1',1",1"'-(η4-cyclobutadiène-tetrakis 1,2,3,4-[2,5,2',5',2"-ter-thiophène-5"-carbaldéhyde])]-(η5-cyclopentadiényl)-cobalt(I) ;
- le [1,1',1",1"'-(η4-cyclobutadiène-tetrakis 1,2,3,4-[2,5,2',5',2"-ter-thiophène-5"-bromo])]-(η5-cyclopentadiényl)-cobalt(I) ;
- le 1,1',1",1"'-(η4-cyclobutadiène-tetrakis 1,2,3,4-[2,5,2',5',2"-ter-thiophène-5"-méthoxy])]-(η5-cyclopentadiényl)-cobalt(I) ;
- le [1,1',1",1"'-(η4-cyclobutadiène-tetrakis 1,2,3,4-[2,5,2',5',2"-ter-thiophène-5"-nitro])]-(η5-cyclopentadiényl)-cobalt(I) ;
- le [1,1',1",1"'-(η4-cyclobutadiène-tetrakis 1,2,3,4-[2,5,2',5',2'-ter-thiophène-(4,4',4")-tris hexyl])]-(-η5-cyclopentadiényl)-cobalt(I) ;
- le [1,1',1",1"'-(η4-cyclobutadiène-tetrakis 1,2,3,4-[2,5,2',5',2"-ter-thiophène-5"-dodécyl])]-(η5-cyclopentadiényl)-cobalt(I) ;
- le [1,1',1",1"'-(η4-cyclobutadiène-tetrakis 1,2,3,4-[2,5,2',5',2"-ter-thiophène-5"-iodo])]-(η5-cyclopentadiényl)-cobalt(I) ;
- le [1,1',1",1"'-(η4-cyclobutadiène-bis 1,3-[2,5,2',5',2"-ter-thiophène-5"-nitro], bis 2,4-[2,5,2',5',2"-terthiophène-5"-méthoxy])]-(η5-cyclopentadiényl)-cobalt(I) ; et
- le [1,1',1",1"'-(η4-cyclobutadiène-bis 1,3-[2,5,2',5',2"-ter-thiophène-5"-bromo], bis 2,4-[2,5,2',5',2"-terthiophène-5"-méthoxy])]-(η5-cyclopentadiényl)-cobalt(I).

5. Cellule de conversion photovoltaïque comprenant au moins un support, une électrode positive, une couche active comprenant au moins un donneur d'électrons et au moins un accepteur d'électrons, et une électrode négative, ladite cellule étant **caractérisée en ce que** le donneur d'électrons est choisi parmi les composés de formule (I-a) et (I-b) tels que définis à l'une quelconque des revendications 1 à 4.

6. Cellule selon la revendication 5, **caractérisée en ce que** l'accepteur d'électrons est choisi parmi les dérivés de fullerène, les nanotubes de carbone, les dérivés du pérylène et les dérivés du tetracyanoquinodiméthane.

7. Cellule selon la revendication 6, **caractérisé en ce que** l'accepteur d'électrons est le [6,6]-phényl-C61-butyrate de méthyle.

8. Cellule selon l'une quelconque des revendications 5 à 7, **caractérisée en ce que** le rapport massique composé de formule (I-a) ou (I-b)/accepteur d'électrons varie de 2/1 à 1/4.

**9.** Cellule selon l'une quelconque des revendications 5 à 8, **caractérisée en ce que** l'électrode négative est une électrode d'aluminium.

**10.** Cellule selon l'une quelconque des revendications 5 à 9, **caractérisée en ce qu'**une couche tampon est intercalée entre la couche active et l'électrode positive, ladite couche tampon étant constituée d'un mélange de poly(3,4-éthylènedioxythiophène) et de poly(styrène sulfonate) de sodium.

**11.** Cellule selon l'une quelconque des revendications précédentes, **caractérisée en ce qu'**une couche tampon est intercalée entre la couche active et l'électrode négative, ladite couche tampon étant constituée d'une couche de fluorure de lithium.

**Patentansprüche**

**1.** Verwendung mindestens eines Kobaltkomplexes der folgenden Formeln (I-a) oder (I-b):

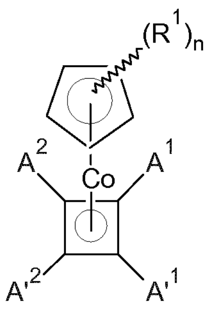
(I-a)

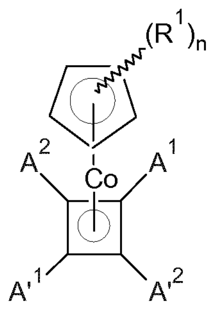
(I-b)

wobei:

- n eine ganze Zahl ist, die von 0 bis 5 schwankt,
- $R^1$ aus I, $C_1$-$C_{12}$-Alkyl, Trimethylsilyl, HgCl, -C(O)-$C_1$-$C_4$-Alkyl und einer eventuell durch ein $C_1$-$C_4$-Alkylradikal substitutierten Oxazolgruppe ausgewählt ist, wobei es sich versteht, dass, wenn n>1, alle $R^1$-Radikale einer Verbindung der gegebenen Formel (I-a) oder (I-b) identisch sind,
- die Gruppen $A^1$, $A'^1$, $A^2$ und $A'^2$ paarweise identisch sind und aus den Gruppen der folgenden Formeln (II- 1) bis (II-9) ausgewählt sind:

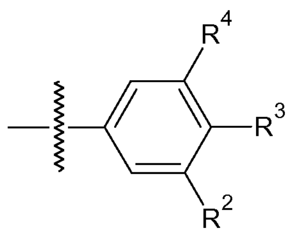
(II-1)

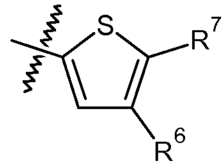
(II-2)

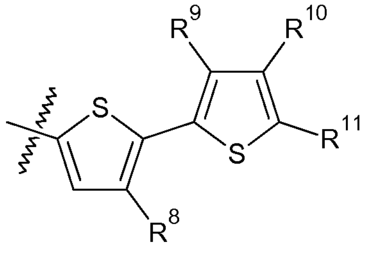
(II-3)

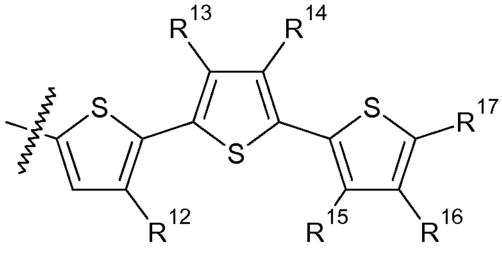
(II-4)

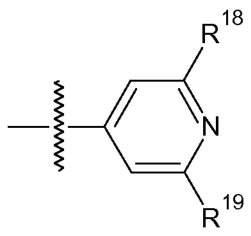

(II-5)

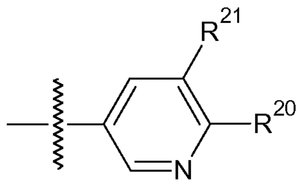

(II-6)

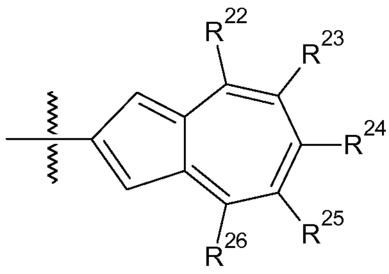

(II-7)

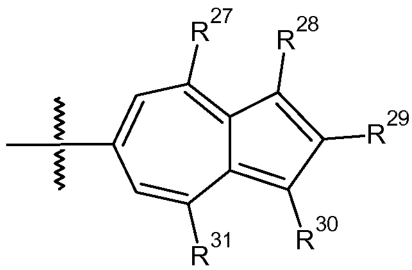

(II-8)

und

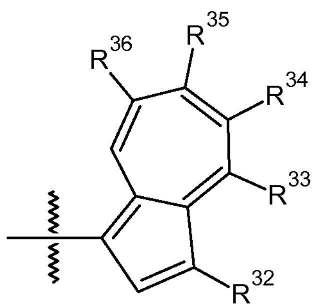

(II-9)

wobei:

- $R^2$, $R^3$ und $R^4$, die identisch oder unterschiedlich sind, ein Wasserstoff-, Jod- oder Bromatom, ein Nitro-, ein lineares $C_1$-$C_{12}$-Alkyl-, Trifluormethyl-, Dialkyl($C_1$-$C_4$)amino-, -C(O)-$C_1$-$C_4$-Alkyl- oder lineares $C_1$-$C_4$-Alcoxy-radikal aufweisen,
- $R^6$, $R^8$, $R^9$, $R^{10}$, $R^{12}$, $R^{13}$, $R^{14}$, $R^{15}$ und $R^{16}$, die identisch oder unterschiedlich sind, ein Wasserstoff oder Bromatom, ein lineares $C_1$-$C_{12}$-Alkyl- oder lineares $C_1$-$C_4$-Alcoxyradikal aufweisen, wobei $R^9$ und $R^{10}$ gemeinsam und/oder $R^{13}$ und $R^{14}$ gemeinsam und/oder $R^{15}$ und $R^{16}$ gemeinsam ebenfalls eine Ethylendioxy-Gruppe (-O-$(CH_2)_2$-O-) bilden können,
- $R^7$, $R^{11}$ und $R^{17}$ ein Wasserstoff-, Brom- oder Jodatom, ein Nitro-, lineares $C_1$-$C_{12}$-Alkyl-, lineares $C_1$-$C_4$-Alcoxy-, -CHO-, -C(O)-$C_1$-$C_4$-Alkyl-, - C(O)$C_1$-$C_4$-Alcoxyradikal oder einen Thiophenzyklus darstellen, der eventuell einen oder mehrere Substituenten trägt, die aus Br, I, Nitro, linearem $C_1$-$C_{12}$-Alkyl, linearem $C_1$-$C_4$-Alcoxy, -C(O)-$C_1$-$C_4$-Alkyl und -C(O)-$C_1$-$C_4$-Alcoxy ausgewählt sind,
- $R^{18}$ bis $R^{36}$, die identisch oder unterschiedlich sind, ein Wasserstoffatom, ein lineares $C_1$-$C_4$-Alkocyradikal, ein Nitro- oder -C(O)-$C_1$-$C_4$-Alcoxyradikal darstellen,

als Elektronendonator und in Kombination mit einem Elektronenakzeptor für die Herstellung einer aktiven Schicht in einer photovoltaischen Konversionszelle.

**2.** Verwendung nach Anspruch 1, **dadurch gekennzeichnet, dass** n gleich 1 oder 2 ist und das oder die $R_1$-Radikale ein Methylradikal darstellt/ darstellen.

**3.** Verwendung nach Anspruch 1, **dadurch gekennzeichnet, dass** die Komplexe der Formeln (I-a) und (I-b) ausgewählt sind aus:

- dem [1,1’,1",1"’-(η4-1,3-cyclobutadien-1,2,3,4-tetrayl)tetrakis-[benzen]](η5-cyclopentadienyl)-cobalt(I),
- dem [1,1’ ,1",1"’-(η4-1,3-cyclobutadien-1,2,3,4-tetrayl)tetrakis-4-n-butyl-benzen]](η5-cyclopentadienyl)-cobalt(I),
- dem [1,1’,1",1"’-(η4-1,3-cyclobutadien-1,2,3,4-tetrayl)tetrakis-[3,5-dimethoxy-benzen]](η5-cyclopentadienyl)-cobalt(I),
- dem [1,1’-[(1,2,3,4-η)-2,4-bis(4-methoxybenzen)-1,3-cyclobutadien-1,3-diyl]bis[phenyl]](r|5-2,4-cyclopentadien-1-yl)-cobalt(I),
- dem [1,1’-[(1,2,3,4-η)-2,4-bis(4-nitrobenzen)-1,3-cyclobutadien-1,3-diyl]bis[phenyl]](η5-2,4-cyclopentadien-1-yl)-cobalt(I),
- dem [1,1’-[(1,2,3,4-η)-2,4-bis(4-nitrobenzen)-1,3-cyclobutadien-1,3-diyl]bis[4-methoxy-benzen]](η5-2,4-cyclopentadien-1-yl)-cobalt(I),
- dem [1,1’-[(1,2,3,4-η)-2,4-bis(4-brombenzen)-1,3-cyclobutadien-1,3-diyl]bis[4-methoxy-benzen]](η5-2,4-cyclopentadien-1-yl)-cobalt(I),
- dem [1,1’, 1",1"’-(η4-1,3-cyclobutadien-1,2,3,4-tetrayl)tetrakis-[4-methylbenzoat]](η5-cyclopentadienyl)-cobalt(I),
- dem [1,1’,1",1"’-(η4-1,3-cyclobutadien-1,2,3,4-tetrayl)tetrakis-[2,2’,5’,bithiophen]]-(η5-cyclopentadienyl)-cobalt(I),
- dem [1,1’,1",1"’-(η4-1,3-cyclobutadien-1,2,3,4-tetrayl)tetrakis[2,2’,5’,2",5"-ter-thiophen]](η5-cyclopentadienyl)-cobalt(I),
- dem [1,1’,1",1"’-(η4-cyclobutadien-tetrakis 1,2,3,4-[2,5,2’,5’,2"-ter-thiophen-5"-carbaldehyd])]-(η5-cyclopentadienyl)-cobalt(I),
- [1,1’,1",1"’-(η4-cyclobutadien-tetrakis 1,2,3,4-[2,5,2’,5’,2"-ter-thiophen-5"-bromo])]-(η5-cyclopentadienyl)-cobalt(I),
- dem [1,1’,1",1"’-(η4-cyclobutadien-tetrakis 1,2,3,4-[2,5,2’,5’,2"-ter-thiophen-5"-methoxy])]-(η5-cyclopentadienyl)-cobalt(I),
- dem [1,1’,1",1"’-(η4-cyclobutadien-tetrakis 1,2,3,4-[2,5,2’,5’,2"-ter-thiophen-5"-nitro])]-(η5-cyclopentadienyl)-cobalt(I),
- dem [1,1’,1",1"’-(η4-cyclobutadien-tetrakis 1,2,3,4-[2,5,2’,5’,2’-ter-thiophen-(4,4’,4")-trishexyl])]-(η5-cyclopentadienyl)-cobalt(I),
- dem [1,1’,1",1"’-(η4-cyclobutadien-tetrakis 1,2,3,4-[2,5,2’,5’,2"-ter-thiophen-5"-dodecyl])]-(η5-cyclopentadienyl)-cobalt(I),
- dem [1,1’,1",1"’-(η4-cyclobutadien-tetrakis 1,2,3,4-[2,5,2’,5’,2"-ter-thiophene-5"-jod])]-(η5-cyclopentadienyl)-cobalt(I),
- dem [1,1’,1",1"’-(η4-cyclobutadien-bis 1,3-[2,5,2’,5’,2"-ter-thiophen-5"-nitro], bis 2,4-[2,5,2’5’,2"-terthiophen-5"-methoxy])]-(η5-cyclopentadienyl)- cobalt(I),
- dem [1,1’,1",1"’-(η4-cyclobutadien-bis 1,3-[2,5,2’,5’,2"-ter-thiophen-5"-brom], bis 2,4-[2,5,2’,5’,2"-terthiophen-5"-methoxy])]-(η5-cyclopentadienyl)-cobalt(I),
- dem [1,1’,1",11"’-(η4-1,3-cyclobutadien-1,2,3,4-tetrayl)tetrakis-[2-thionyl]](η5-cyclopentadienyl)-cobalt(I),
- dem [1,1’,1",1"’-(η4-1,3-cyclobutadien-1,2,3,4-tetrayl)tetrakis-[3-pyridyl]](η5-cyclopentadienyl)-cobalt(I),
- dem [1,1’,1",1"’-(η4-1,3-cyclobutadien-1,2,3,4-tetrayl)tetrakis-[4-pyridyl]](η5-cyclopentadienyl)-cobalt(I),
- dem [1,1’,1",1"’-(η4-1,3-cyclobutadien-1,2,3,4-tetrayl)tetrakis-[1-azulenyl]](η5-cyclopentadienyl)-cobalt(I),
- dem [1,1’,1",1"’-(η4-1,3-cyclobutadien-1,2,3,4-tetrayl)tetrakis-[2-azulenyl]](η5-cyclopentadienyl)-cobalt(I) und
- dem [1,1’,1",1"’-(η4-1,3-cyclobutadien-1,2,3,4-tetrayl)tetrakis-[6-azulenyl]](η5-cyclopentadienyl)-cobalt(I).

**4.** Verwendung nach Anspruch 1, **dadurch gekennzeichnet, dass** die Komplexe der Formeln (I-a) und (I-b) ausgewählt sind aus:

- dem [1,1’,1",1"’-(η4-1,3-cyclobutadien-1,2,3,4-tetrayl)tetrakis-[2,2’,5’,bithiophen]]-(η5-cyclopentadienyl)-cobalt(I),

- dem [1,1',1",1"'-(η4-1,3-cyclobutadien-1,2,3,4-tetrayl)tetrakis[2,2',5',2",5"-ter-thiophen]](η5-cyclopentadienyl)-cobalt(I),
- dem [1,1',1",1"'-(η4-cyclobutadien-tetrakis 1,2,3,4-[2,5,2',5',2"-ter-thiophen-5"-carbaldehyd])]- (η5-cyclopentadienyl)-cobalt(I),
- dem [1,1',1",1"'-(η4-cyclobutadien-tetrakis 1,2,3,4-[2,5,2',5',2"-ter-thiophen-5"-brom])]-(η5-cyclopentadienyl)-cobalt(I),
- dem [1,1',1",1"'-(η4-cyclobutadien-tetrakis 1,2,3,4-[2,5,2',5',2"-ter-thiophen-5"-methoxy])] (η5-cyclopentadienyl)-cobalt(I),
- dem [1,1',1",1"'-(η4-cyclobutadien-tetrakis 1,2,3,4-[2,5,2',5',2"-ter-thiophen-5"-nitro])]-(η5-cyclopentadienyl)-cobalt(I),
- dem [1,1',1",1"'-(η4-cyclobutadien-tetrakis 1,2,3,4-[2,5,2',5',2'-ter-thiophen-(4,4',4")-tris hexyl])]-(η5-cyclopentadienyl)-cobalt(I),
- dem [1,1',1",1"'-(η4-cyclobutadien-tetrakis 1,2,3,4-[2,5,2',5',2"-ter-thiophen-5"-dodecyl])]-(η5-cyclopentadienyl)-cobalt(I),
- dem [1,1',1",1"'-(η4-cyclobutadien-tetrakis 1,2,3,4-[2,5,2',5',2"-ter-thiophene-5"-jod])]-(η5-cyclopentadienyl)-cobalt(I),
- dem [1,1',1",1"'-(η4-cyclobutadien-bis 1,3-[2,5,2',5',2"-ter-thiophen-5"-nitro], bis 2,4-[2,5,2',5',2"-terthiophen-5"-methoxy])]-(η5-cyclopentadienyl)- cobalt(I) und
- dem [1,1',1",1"'-(η4-cyclobutadien-bis 1,3-[2,5,2',5',2"-ter-thiophen-5"-brom], bis 2,4-[2,5,2',5',2"-terthiophen-5"-methoxy])]-(η5-cyclopentadienyl)-cobalt(I).

**5.** Photovoltaische Konversionszelle, die mindestens einen Träger, eine positive Elektrode, eine aktive Schicht, die mindestens einen Elektrodendonator und mindestens einen Elektrodenakzeptor umfasst, und eine negative Elektrode umfasst, wobei die Zelle **dadurch gekennzeichnet ist, dass** der Elektrodendonator aus den Verbindungen der Formel (I-a) und (I-b) nach einem der Ansprüche 1 bis 4 ausgewählt ist.

**6.** Zelle nach Anspruch 5, **dadurch gekennzeichnet, dass** der Elektronenakzeptor aus den Fullerenderivaten, den Kohlenstoff-Nanoröhrchen, den Perylenderivaten und den Derivaten des Tetracyanoquinodimethans ausgewählt ist.

**7.** Zelle nach Anspruch 6, **dadurch gekennzeichnet, dass** der Elektronenakzeptor das [6,6]-Phenyl-C61-methylbutyrat ist.

**8.** Zelle nach einem der Ansprüche 5 bis 7, **dadurch gekennzeichnet, dass** das Massenverhältnis Verbindung der Formel (I-a) der (I-b)/Elektronenakzeptor von 2/1 bis 1/4 schwankt.

**9.** Zelle nach einem der Ansprüche 5 bis 8, **dadurch gekennzeichnet, dass** die negative Elektrode eine Aluminiumelektrode ist.

**10.** Zelle nach einem der Ansprüche 5 bis 9, **dadurch gekennzeichnet, dass** sich zwischen der aktiven Schicht und der positiven Elektrode eine Pufferschicht befindet, wobei die Pufferschicht aus einem Gemisch aus Poly(3,4-ethylendioxythiophen) und Natrium-poly(styrensulfonat) besteht.

**11.** Zelle nach einem der vorangehenden Ansprüche, **dadurch gekennzeichnet, dass** sich zwischen der aktiven Schicht und der negativen Elektrode eine Pufferschicht befindet, wobei die Pufferschicht aus einer Lithiumfluoridschicht besteht.

## Claims

**1.** The use of at least one cobalt complex of formula (I-a) or (I-b) below:

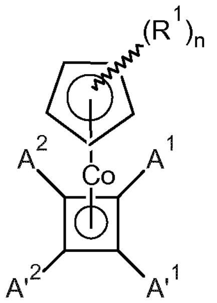

(I-a)

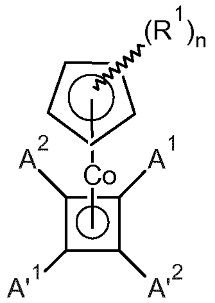

(I-b)

wherein:

- n is an integer that varies from 0 to 5;
- $R^1$ is chosen from I, $C_1$-$C_{12}$ alkyl, trimethylsilyl, HgCl, -C(O)($C_1$-$C_4$)alkyl, and an oxazole group optionally substituted by a $C_1$-$C_4$ alkyl radical, it being understood that when n>1, all the $R^1$ radicals of a given compound of formula (I-a) or (I-b) are identical,
- the groups $A^1$, $A'^1$, $A^2$ and $A'^2$ are identical in pairs and are chosen from the groups of formulae (II-1) to (II-9) below:

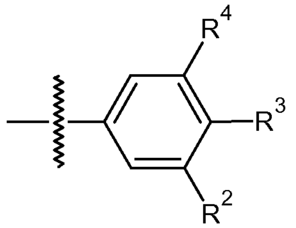

(II-1)

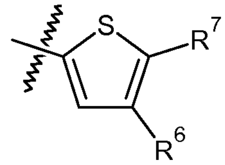

(II-2)

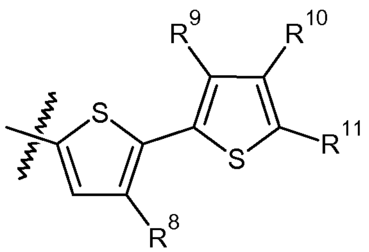

(II-3)

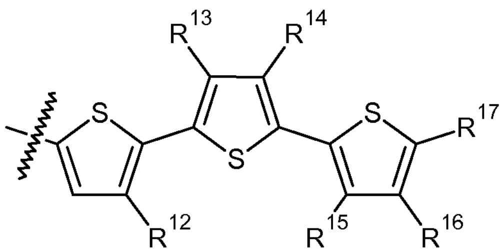

(II-4)

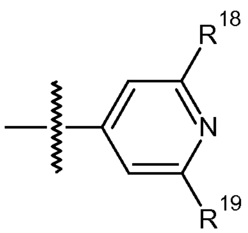

(II-5)

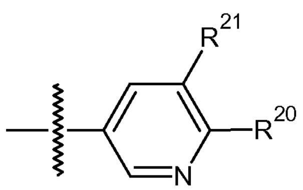

(II-6)

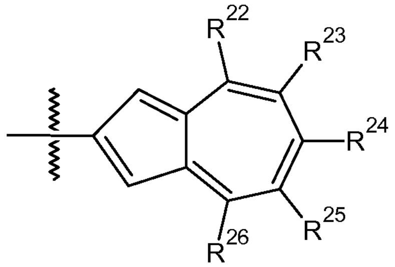

(II-7)

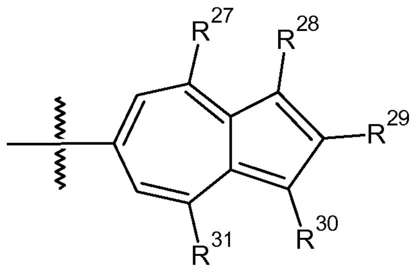

(II-8)

;

and

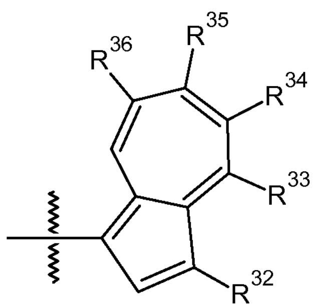

(II-9)

wherein:

- $R^2$, $R^3$, and $R^4$, which are identical or different, represent a hydrogen, iodine or bromine atom, a nitro, linear $C_1$-$C_{12}$ alkyl, trifluoromethyl, di($C_1$-$C_4$)alkylamino, -C(O)($C_1$-$C_4$)alkyl or linear $C_1$-$C_4$ alkoxy radical;
- $R^6$, $R^8$, $R^9$, $R^{10}$, $R^{12}$, $R^{13}$, $R^{14}$, $R^{15}$ and $R^{16}$, which are identical or different, represent a hydrogen or bromine atom, a linear $C_1$-$C_{12}$ alkyl or linear $C_1$-$C_4$ alkoxy radical, $R^9$ and $R^{10}$ together and/or $R^{13}$ and $R^{14}$ together and/or $R^{15}$ and $R^{16}$ together may also form an ethylenedioxy group (-O-$(CH_2)_2$-O-);
- $R^7$, $R^{11}$ and $R^{17}$ represent a hydrogen, bromine or iodine atom, a nitro, linear $C_1$-$C_{12}$ alkyl, linear $C_1$-$C_4$ alkoxy, -CHO, -C(O)($C_1$-$C_4$)alkyl or -C(O)($C_1$-$C_4$)alkoxy radical or a thiophene ring optionally bearing one or more substituents chosen from Br, I, nitro, linear $C_1$-$C_{12}$ alkyl, linear $C_1$-$C_4$ alkoxy, -C(O)($C_1$-$C_4$)alkyl and -C(O)($C_1$-$C_4$)alkoxy;
- $R^{18}$ to $R^{36}$, which are identical or different, represent a hydrogen atom, a linear $C_1$-$C_4$ alkoxy radical, a nitro radical or a -C(O)($C_1$-$C_4$)alkoxy radical,

as a electron donor and in combination with an electron acceptor, for the preparation of an active layer in a photovoltaic conversion cell.

2. The use as claimed in claim 1, **characterized in that** n is equal to 1 or 2, and the $R_1$ radical(s) represent(s) a methyl radical.

3. The use as claimed in claim 1, **characterized in that** the complexes of formulae (I-a) and (I-b) are chosen from:

- [1,1',1'',1'''-(η4-1,3-cyclobutadiene-1,2,3,4-tetrayl)tetrakis[benzene]](η5-cyclopentadienyl)cobalt(I);
- [1,1',1'',1'''-(η4-1,3-cyclobutadiene-1,2,3,4-tetrayl)tetrakis-4-n-butyl-benzene]](η5-cyclopentadienyl)cobalt(I);
- [1,1',1'',1'''-(η4-1,3-cyclobutadiene-1,2,3,4-tetrayl)tetrakis[3,5-dimethoxy-benzene]](η5-cyclopentadienyl)cobalt(I);
- [1,1'-[(1,2,3,4-η)-2,4-bis(4-methoxybenzene)-1,3-cyclobutadien-1,3-diyl]-bis[phenyl]](η5-2,4-cyclopentadien-1-yl)cobalt(I);
- [1,1'-[(1,2,3,4-η)-2,4-bis(4-nitrobenzene)-1,3-cyclobutadien-1,3-diyl]bis-[phenyl]](η5-2,4-cyclopentadien-1-yl)cobalt(I);
- [1,1'-[(1,2,3,4-η)-2,4-bis(4-nitrobenzene)-1,3-cyclobutadien-1,3-diyl]bis[4-methoxybenzene]](η5-2,4-cyclopentadien-1-yl)cobalt(I);
- [1,1'-[(1,2,3,4-η)-2,4-bis(4-bromobenzene)-1,3-cyclobutadien-1,3-diyl]bis-[4-methoxybenzene]](η5-2,4-cyclopentadien-1-yl)cobalt(I);
- [1,1',1'',1'''-(η4-1,3-cyclobutadiene-1,2,3,4-tetrayl)tetrakis[4-methyl benzoate]](η5-cyclopentadienyl)cobalt(I);
- [1,1',1'',1'''-(η4-1,3-cyclobutadiene-1,2,3,4-tetrayl)tetrakis[2,2',5'-bithiophene]](η5-cyclopentadienyl)cobalt(I);

- [1,1',1",1"'-(-η4-1,3-cyclobutadiene-1,2,3,4-tetrayl)tetrakis[2,2',5',2",5"-terthiophene]](η5-cyclopentadienyl)cobalt(I);
- [1,1',1",1"'-(η4-cyclobutadiene-tetrakis 1,2,3,4-[2,5,2',5',2"-terthiophene-5"-carbaldehyde])]-(η5-cyclopentadienyl)cobalt(I);
- [1,1',1",1"'-(η4-cyclobutadiene-tetrakis 1,2,3,4-[2,5,2',5',2"-terthiophene-5"-bromo])](η5-cyclopentadienyl)cobalt(I);
- 1,1',",11"'-(η4-cyclobutadiene-tetrakis 1,2,3,4-[2,5,2',5',2"-terthiophene-5"-methoxy])](η5-cyclopentadienyl)cobalt(I);
- [1,1',1",1"'-(η4-cyclobutadiene-tetrakis 1,2,3,4-[2,5,2',5',2"-terthiophene-5"-nitro])](η5-cyclopentadienyl)cobalt(I);
- [1,1',11",1"'-(η4-cyclobutadiene-tetrakis 1,2,3,4-[2,5,2',5',2'-terthiophene-(4,4',4")-trishexyl])](η5-cyclopentadienyl)cobalt(I);
- [1,1',1",1"'-(η4-cyclobutadiene-tetrakis 1,2,3,4-[2,5,2',5',2"-terthiophene-5"-dodecyl])](η5-cyclopentadienyl)cobalt(I);
- [1,1',1",1"'-(η4-cyclobutadiene-tetrakis 1,2,3,4-[2,5,2',5',2"-terthiophene-5"-iodo])](η5-cyclopentadienyl)cobalt(I);
- [1,1',1",1"'-(η4-cyclobutadiene-bis 1,3-[2,5,2',5',2"-terthiophene-5"-nitro], bis 2,4-[2,5,2',5',2"-terthiophene-5"-methoxy])](η5-cyclopentadienyl)-cobalt(I);
- [1,1',1",1"'-(η4-cyclobutadiene-bis 1,3-[2,5,2',5',2"-terthiophene-5"-bromo], bis 2,4-[2,5,2',5',2"-terthiophene-5"-methoxy])](η5-cyclopentadienyl)cobalt(I);
- [1,1',1",1"'-(η4-1,3-cyclobutadiene-1,2,3,4-tetrayl)tetrakis[2-thionyl]](η5-cyclopentadienyl)cobalt(I);
- [1,1',1",1"'-(η4-1,3-cyclobutadiene-1,2,3,4-tetrayl)tetrakis[3-pyridyl]](η5-cyclopentadienyl)cobalt(I);
- [1,1',1",1"'-(η4-1,3-cyclobutadiene-1,2,3,4-tetrayl)tetrakis[4-pyridyl]](η5-cyclopentadienyl)cobalt(I);
- [1,1',1",1"'-(η4-1,3-cyclobutadiene-1,2,3,4-tetrayl)tetrakis[1-azulenyl]](η5-cyclopentadienyl)cobalt(I);
- [1,1'1",1"'-(η4-1,3-cyclobutadiene-1,2,3,4-tetrayl)tetrakis[2-azulenyl]](η5-cyclopentadienyl)cobalt(I); and
- [1,1',1",1"'-(η4-1,3-cyclobutadiene-1,2,3,4-tetrayl)tetrakis[6-azulenyl]](η5-cyclopentadienyl)cobalt(I).

4. The use as claimed in claim 1, **characterized in that** the complexes of formulae (I-a) and (I-b) are chosen from:

- [1,1',1",1"'-(η4-1,3-cyclobutadiene-1,2,3,4-tetrayl)tetrakis[2,2',5'-bithiophene]](η5-cyclopentadienyl)cobalt(I);
- [1,1',1",1"'-(η4-1,3-cyclobutadiene-1,2,3,4-tetrayl)tetrakis[2,2',5',2",5"-terthiophene]](η5-cyclopentadienyl)cobalt(I);
- [1,1',1",1"'-(η4-cyclobutadiene-tetrakis 1,2,3,4-[2,5,2',5',2"-terthiophene-5"-carbaldehyde])](η5-cyclopentadienyl)cobalt(I);
- [1,1',",11"'-(η4-cyclobutadiene-tetrakis 1,2,3,4-[2,5,2',5',2"-terthiophene-5"-bromo])](η5-cyclopentadienyl)cobalt(I);
- 1,1',1 1",1"'-(η4-cyclobutadiene-tetrakis 1,2,3,4-[2,5,2',5',2"-terthiophene-5"-methoxy])](η5-cyclopentadienyl)cobalt(I);
- [1,1',1",1"'-(η4-cyclobutadiene-tetrakis 1,2,3,4-[2,5,2',5',2"-terthiophene-5"-nitro])](η5-cyclopentadienyl)cobalt(I);
- [1,1',1",1"'-(η4-cyclobutadiene-tetrakis 1,2,3,4-[2,5,2',5',2'-terthiophene-(4,4',4")-trishexyl])](η5-cyclopentadienyl)cobalt(I);
- [1,1',1",1"'-(η4-cyclobutadiene-tetrakis 1,2,3,4-[2,5,2',5',2"-terthiophene-5"-dodecyl])](η5-cyclopentadienyl)cobalt(I);
- [1,1',1",1"'-(η4-cyclobutadiene-tetrakis 1,2,3,4-[2,5,2',5',2"-terthiophene-5"-iodo])](η5-cyclopentadienyl)cobalt(I);
- [1,1',1",1"'-(η4-cyclobutadiene-bis 1,3-[2,5,2',5',2"-terthiophene-5"-nitro], bis 2,4-[2,5,2',5',2"-terthiophene-5"-methoxy])](η5-cyclopentadienyl)-cobalt(I); and
- [1,1',1",1"'-(η4-cyclobutadiene-bis 1,3-[2,5,2',5',2"-terthiophene-5"-bromo], bis 2,4-[2,5,2',5',2"-terthiophene-5"-methoxy])](η5-cyclopenta-dienyl)cobalt(I).

5. A photovoltaic conversion cell comprising at least one support, a positive electrode, an active layer comprising at least one electron donor and at least one electron acceptor, and a negative electrode, said cell being **characterized in that** the electron donor is chosen from the compounds of formulae (I-a) and (I-b) as defined in any one of claims 1 to 4.

6. The cell as claimed in claim 5, **characterized in that** the electron acceptor is chosen from fullerene derivatives, carbon nanotubes, perylene derivatives and tetracyanoquinodimethane derivatives.

7. The cell as claimed in claim 6, **characterized in that** the electron acceptor is methyl [6,6]-phenyl-C61-butyrate.

8. The cell as claimed in any one of claims 5 to 7, **characterized in that** the compound of formula (I-a) or (I-b)/electron acceptor weight ratio varies from 2/1 to 1/4.

9. The cell as claimed in any one of claims 5 to 8, **characterized in that** the negative electrode is an aluminum electrode.

10. The cell as claimed in any one of claims 5 to 9, **characterized in that** a buffer layer is inserted between the active layer and the positive electrode, said buffer layer consisting of a mixture of poly(3,4-ethylenedioxythiophene) and poly(sodium styrenesulfonate).

11. The cell as claimed in any one of the preceding claims, **characterized in that** a buffer layer is inserted between the active layer and the negative electrode, said buffer layer consisting of a layer of lithium fluoride.

# FIGURE 1

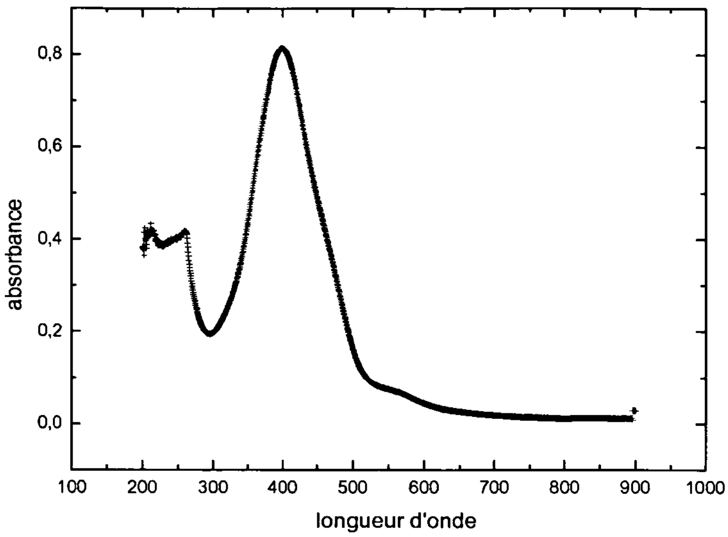


# FIGURE 2

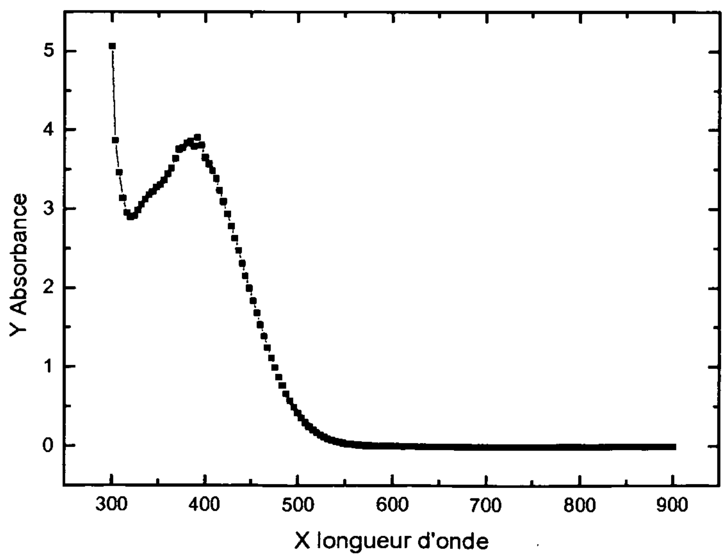

## FIGURE 3

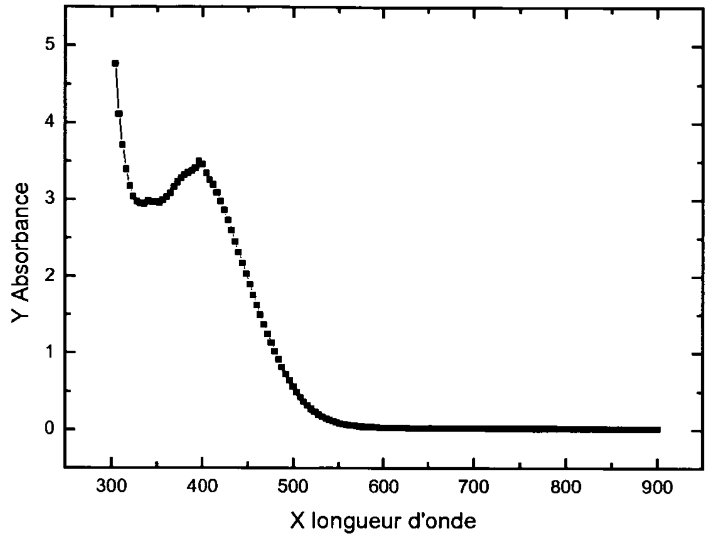


## FIGURE 4

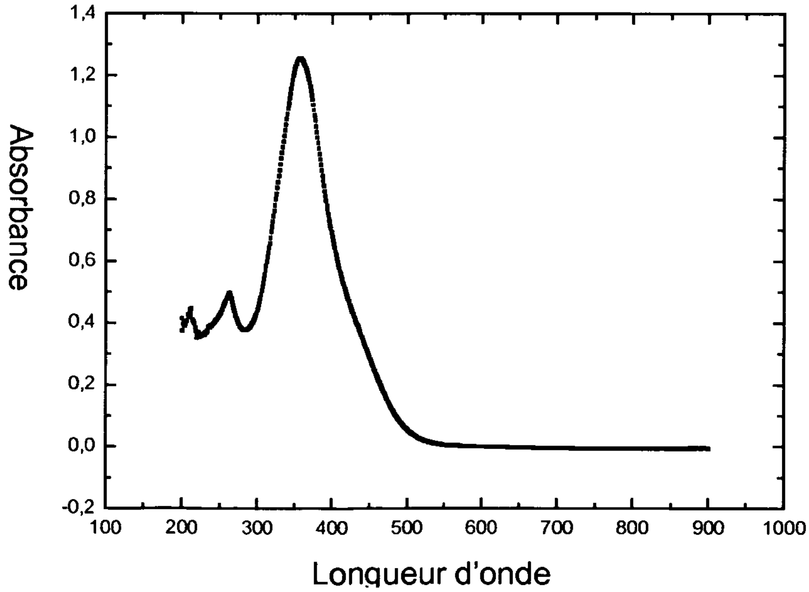

**FIGURE 5**

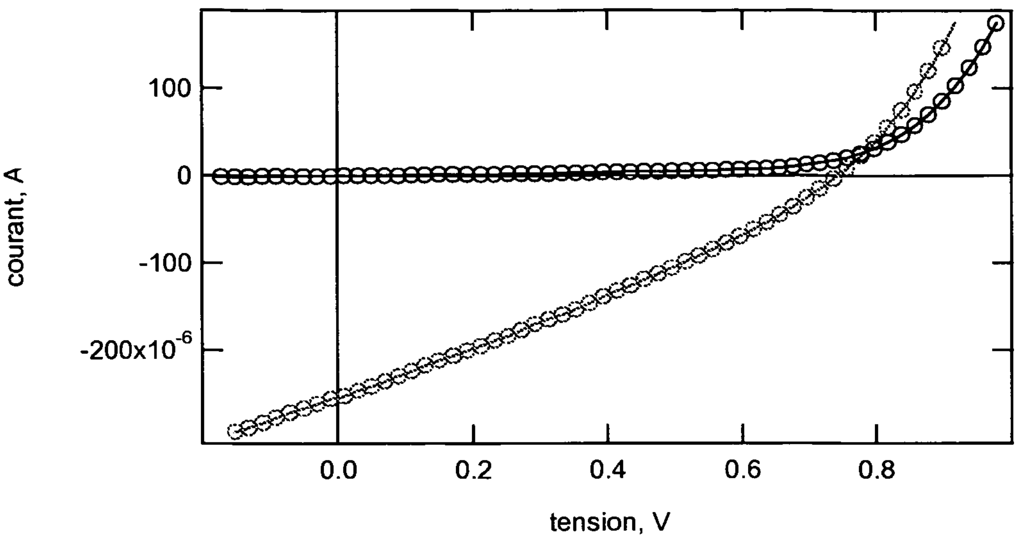


**FIGURE 6**

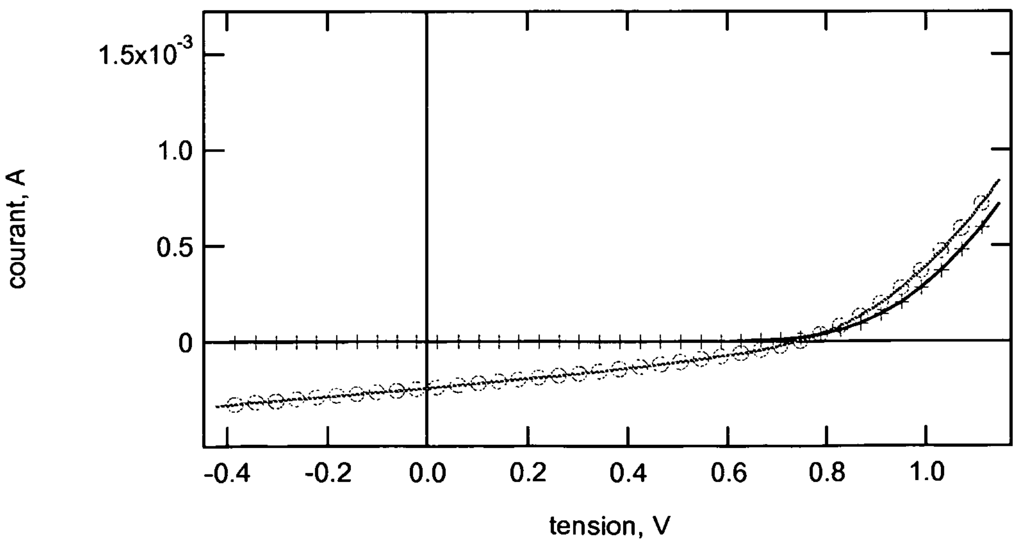

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- WO 2004008554 A2


### Littérature non-brevet citée dans la description


- **VANLAEKA et al.** *Solar Energy Materials and Solar Cells,* 2006, vol. 90 (14), 2150-2158
- **C. J. BRABEC et al.** *Synthetic Metals,* 1999, vol. 102, 861-864
- **F. SILVESTRI et al.** *J. Am. Chem. Soc.,* 2008, vol. 130, 17640-17641
- **Z. XU et al.** *Journal of Applied Physics,* 2008, vol. 103, 043909-1, 8
- **W. K. CHAN et al.** *Newsroom,* 2009
- **CHAMBERLAIN G. A.** *Solar Cells,* 1983, vol. 8, 47-83
- **XU Z.** *Journal of Applied Physics,* 2008, vol. 103, 043909-1
- **SONOGASHIRA K. et al.** *Tetrahedron Letters,* 1975, 4467
- **M. LAMBERTO et al.** *Tetrahedron Letters,* 2005, vol. 46 (29), 4895-4899
- **S. ITO et al.** *J. Org. Chem.,* 2002, vol. 67 (21), 7295-7302
- **S. ITO et al.** *Tetrahedron Letters,* 2004, vol. 45 (14), 2891-2894
- **K. M. MALONEY et al.** *Journal of Organic Chemistry,* 2009, vol. 74 (14), 5111-5114
- **J. B. PRESS et al.** *J. Org. Chem.,* 1979, vol. 44 (19), 3293
- **S. KAWAMORITA et al.** *J. Org. Chem.,* 2010, vol. 75 (11), 3855-3858
- **S. W. HELL et al.** *Angew. Chem. Int. Ed.,* 2006, vol. 45, 7462-7465
- **A. H. M. ELWAHY et al.** *Euro. J. Org. Chem.,* 2010, vol. 2, 265-27
- **A. H. M. ELWAHY et al.** *Tetrahedron Letters,* 2000, vol. 41 (16), 2859-2862
- **E. M. HARCOURT et al.** *Organometallics,* 2008, vol. 27 (7), 1653-1656
- **U. S. SORENSEN ; E. POMBO-VILLAR.** *Tetrahedron,* 2005, vol. 61 (10), 2697-2703
- **A. GENY et al.** *Ang. Chem. Int Ed.,* 2009, vol. 48 (10), 1810-1813
- **W.H. MOSER et al.** *J. Org. Chem.,* 2006, vol. 71 (17), 6542-6546
- **J. KALISIAK et al.** *Org. Lett.,* 2008, vol. 10 (15), 3171-3174
- **Y.T. WU et al.** *Angew. Chem. Int. Ed.,* 2008, vol. 47 (51), 9891-9894
- **B. H. LIPSHUTZ et al.** *Organic Letters,* 2008, vol. 10 (17), 3793-3796
- **T. MINO et al.** *J. Org. Chem.,* 2006, vol. 71 (25), 9499-9502
- **Y. NISHIHARA et al.** *Tet. Lett.,* 2009, vol. 50 (32), 4643-4646
- **G.W. KABALKA et al.** *Tet. Lett.,* 2006, vol. 47 (7), 1133-1136
- **Y.T. WU et al.** *Angew. Chem. Int., Ed,* 2008, vol. 47 (51), 9891-9894
- **T. B. PATRICK et al.** *J. Org. Chem.,* 1974, vol. 39 (25), 3791-2
- **J. NAKAYAMA et al.** *Heterocycles,* 1992, vol. 34 (8), 1487-90
- **C.J. BRABEC et al.** *Adv. Mater.,* 2009, vol. 21, 1323-1338